# EUROPÄISCHE PATENTANMELDUNG

(11) **EP 4 257 904 A1**
(43) Veröffentlichungstag der Anmeldung: **11.10.2023**
(21) Anmeldenummer: 22177057.1
(22) Anmeldetag: 02.06.2022
(51) Int. Cl.: F26B 3/28, B05D 3/06, B29C 35/08, F26B 3/30

(54) **GEKÜHLTES INFRAROT- ODER UV-MODUL**

(30) Priorität: 08.04.2022 CN 202210369800
(71) Anmelder: Heraeus Noblelight GmbH, 63450 Hanau (DE); Heraeus Noblelight (Shenyang) Ltd., Shenyang 110141 (CN)
(72) Erfinder: Büngener, Jens, 63801 Kleinostheim (DE); von Riewel, Larisa, 63801 Kleinostheim (DE); Ding, Jing, Shanghai, 200233 (CN); Xu, Yantao, Shanghai, 200233 (CN)
(74) Vertreter: Heraeus IP

(57) **Zusammenfassung**

Die Erfindung betrifft ein IR- oder UV-Modul aufweisend zumindest einen Strahler (1), ein Modulgehäuse (2) mit einem Fenster (3), das den Strahler (1) umhüllt, wobei der Strahler (1) derart in dem Modulgehäuse (2) angeordnet ist, dass abgestrahlte Strahlung durch das Fenster (3) aus dem Modul herausstrahlt, wobei das Modulgehäuse (2) eine Einlassöffnung (4) zum Zuführen eines Gasstroms in das Modulgehäuse (2) hinein und zumindest eine Ablassöffnung (5) zum Ableiten des Gasstroms aus dem Modulgehäuse (2) heraus aufweist, wobei das Modulgehäuse (2) eine Leitung (6) zum Leiten des Gasstroms aus der Einlassöffnung (4) über eine innenliegende Oberfläche (7) des Fensters (3) zu der zumindest einen Ablassöffnung (5) aufweist, wobei das Modulgehäuse (2) eine Gasströmungsaufteilungseinrichtung (8) aufweist, die den Gasstrom innerhalb des Modulgehäuses (2) in mehrere Gasströmungen aufteilt und wobei das Modulgehäuse (2) die mehreren Gasströmungen derart leitet, dass die mehreren Gasströmungen die innenliegende Oberfläche (7) des Fensters (3) abschnittsweise überspülen. Die Erfindung betrifft auch eine Bearbeitungsanlage mit einem solchen IR- oder UV-Modul und ein Verfahren zum Betreiben eines IR- oder UV-Moduls oder einer Bearbeitungsanlage.

## Beschreibung

Die Erfindung betrifft ein Infrarot-Modul (IR-Modul) mit zumindest einem Infrarotstrahler und einem Modulgehäuse mit einem Fenster und ein Ultraviolett-Modul (UV-Modul) mit zumindest einem Ultraviolett-Strahler (UV-Strahler) und einem Modulgehäuse mit einem Fenster. Die Erfindung betrifft auch eine Trocknungsanlage mit einem solchen Infrarot-Modul, eine Härtungsanlange mit einem solchen UV-Modul und ein Verfahren zum Betreiben eines solchen Infrarot-Moduls, eines solchen UV-Moduls, einer solchen Trocknungsanlage oder einer solchen Härtungsanlage. Insbesondere ist das Infrarot-Modul und die Trocknungsanlage zur Trocknung von Elektroden in entzündlicher Atmosphäre und zur Trocknung von "Slurry" (Aufschlämmungen) in der Kathodenfertigung geeignet und vorgesehen. Erfindungsgegenstand ist somit und insbesondere ein Infrarot-Modul umfassend eine IR-Quelle in Form von zumindest einem Infrarotstrahler, wobei der zumindest eine Infrarotstrahler bevorzugt eine Metallwendel, ein Metallgeflecht, ein Metallband, eine Leiterbahn, ein Karbonband, ein Karbongeflecht oder ein Keramikbauteil zur Erzeugung der Infrarotstrahlung nutzt.

Bei der Fertigung von Kathoden für Lithium-Ionen-Akkumulatoren werden Trocknungsgeräte verwendet, die bei niedrigen Temperaturen arbeiten. Hierzu kommen neben warmen oder heißen Gasströmungen auch Infrarotstrahler (IR-Strahler) zum Einsatz, mit denen beschichtete Elektroden zu deren Trocknung bestrahlt werden. Dabei entweichen entzündliche Lösungsmittelbestandteile, die sich entzünden können. Daher dürfen die Temperaturen nicht zu hoch sein und es darf kein Kontakt mit heißen Oberflächen der Infrarotstrahler entstehen, an denen sich die brennbaren Anteile des Gases entzünden könnten.

Bei Trocknungsprozessen oder Härtungsprozessen in entzündlichen Atmosphären dürfen folglich die Höchsttemperaturen der Oberflächen, welche mit dem entzündlichen Gasgemisch in Berührung stehen, den Zündpunkt eben dieses Gasgemisches nicht erreichen. Dies erfordert Systeme mit fest definierter Höchsttemperatur im Kontakt mit den entzündlichen Gasen. Dies gilt insbesondere dann, wenn im Trocknungsbereich oder Härtungsbereich bereits erhöhte (hohe) Temperaturen vorliegen.

Die US 10 739 069 B2 offenbart einen Niedertemperatur-Trocknungs-Apparat ("Lowtemperature drying apparatus"), in dem ein Trockenraum vorgesehen ist, welcher durch eine für Infrarotstrahlung durchlässige (IR-transmittierend) Scheibe räumlich von mehreren länglichen Infrarotstrahlern getrennt ist. Um eine niedrige Temperatur im Trockenraum zu gewährleisten, wird ein kühlendes Fluid durch Be- und Entlüftungsschlitze durch den Trockenraum geführt. Hierdurch wird sowohl der zu trocknende Film als auch IR-transmittierende Scheibe gekühlt. Das Hindurchführen von Kühlmitteln durch den Trockenraum hat einige Nachteile: Zum einen kann es zu einer Kontamination eines zu trocknenden Films oder einer zu trocknenden Beschichtung kommen, wenn das Kühlmittel nicht rein genug ist. Zum anderen wird der Trocknungsprozess durch das Kühlen des zu trocknenden Films oder der zu trocknenden Beschichtung verlangsamt.

Die US 10 739 069 B2 sieht zudem vor, dass auch die Infrarotstrahler selbst gekühlt werden. Die Infrarotstrahler umfassen einen Strahlerkörper bestehend aus einem Heizelement und einem inneren Hüllrohr. Der Strahlerkörper ist wiederum von einem äußeren Hüllrohr umgeben, welches über Kühlmitteleinlässe und Kühlmittelauslässe verfügt. Im Betrieb wird durch den Kühlmitteleinlass ein Kühlmittel in den Zwischenraum zwischen innerem Hüllrohr und äußerem Hüllrohr eingebracht. Das Kühlmittel wird dann am Strahlerkörper entlanggeführt bevor es über den Kühlmittelauslass wieder aus dem äußeren Hüllrohr herausgeführt wird. Das Kühlen äußeren Hüllrohrs ist wichtig, da es mit entzündlichen Gasen in Kontakt kommen kann, die durch Ausgasen des trocknenden Slurrys entstehen. Durch das Kühlen wird vermieden, dass sich die entzündlichen Gase an der Oberfläche des Hüllrohrs entzünden können.

Nachteilig ist an diesem Aufbau, dass der Strahlerkörper noch immer heiße Bereiche aufweist. Eine naheliegende Lösung des Problems besteht darin, die Kühlleistung zu erhöhen, indem eine stärkere Strömung des Fluids bereitgestellt wird. So könnte der Kühlmitteldurchfluss erhöht werden. Hier sind aber physikalische Grenzen gesetzt, was Druckstabilität und Dichtigkeit des Aufbaus betrifft. Zudem sind Systeme mit hohem Kühlmitteldurchfluss regelmäßig sehr laut. Auch wäre es möglich, die Anbindung der Oberfläche des Strahlerkörpers an den Fluidstrom zu verbessern. Beides ist mit erheblichem Aufwand bei der Herstellung verbunden. Zudem wird auch dann keine gleichmäßige Kühlung des Strahlerkörpers erreicht. Es wurde im Rahmen der vorliegenden Erfindung gefunden, dass an einem Ende des äußeren Hüllrohrs ein kühles Kühlmittel eingeleitet, dass sich das Kühlmittel aber beim Entlangströmen am Strahlerkörper kontinuierlich aufheizt, so dass die Kühlungsleistung am Strahlerkörper mit größer werdendem Abstand zum Kühlmitteleinlass signifikant schlechter wird. Die Temperatur von Strahlerkörper und äußerem Hüllrohr nimmt also mit größer werdendem Abstand zum Kühlmitteleinlass stetig zu. Dieser Umstand erschwert das kontrollierte Einhalten einer maximalen Temperatur erheblich und erhöht den Aufwand das Einhalten der maximalen Temperatur sicherzustellen. Des Weiteren sind aus dem Stand der Technik wie beispielsweise der JP 2013-057 438 A Trocknungsanlagen bekannt, bei denen der Trocknungsprozess mittels heißer (120 °C bis 150 °C) Trocknungsgase erfolgt. Hierbei wird die mit dem zu trocknenden Film beschichtete Substratbahn in einem schwebenden Verfahren durch den Ofen geleitet. Im Ofen sind abwechselnd Gasdüsen ober und unterhalb der Substratbahn angeordnet und halten diese durch kontinuierliche Gasströme von oben und unten in der Schwebe. Der Trocknungsprozess erfolgt durch die Temperatur des Trocknungsgases.

Solche Trocknungsanlagen benötigen viel Platz. Eine platzsparende Erweiterung der Linien mit weiteren Heißluftsystemen ist nicht möglich. Zudem findet bei solchen Trocknungsanlagen die Trocknung des zu trocknenden Films oder der zu trocknenden Beschichtung von außen nach innen durch Wärmeleitung statt. Hierdurch wird eine Migration des im Slurry enthaltenen Binders begünstigt, welche sich negativ auf die Eigenschaften des Endproduktes auswirken kann.

Infrarotstrahler (insbesondere mit angepasster Wellenlänge) verbessern die Eigenschaften der zu fertigenden Elektroden und erhöhen so die Effizienz der zu fertigenden Batterie. Die Infrarotstrahlung kann in das Volumen des zu trocknenden Films oder der zu trocknenden Beschichtung eindringen. Die Migration des Binders wird durch eine gleichmäßigere Trocknung über die gesamte Filmdicke beziehungsweise Beschichtungsdicke unterdrückt.

UV-Strahler können beispielsweise zur Härtung von Kunststoffen eingesetzt werden. Auch bei solchen Härtungsverfahren kann es sinnvoll sein, die Temperatur an der Oberfläche des UV-Moduls gering zu halten. Da Entstehen von Hotspots ist auch hier nachteilig.

Die Aufgabe der Erfindung besteht also darin, die Nachteile des Stands der Technik zu überwinden. Insbesondere soll ein Infrarot-Modul und ein UV-Modul und ein Verfahren zu deren Betrieb bereitgestellt werden, dessen zu einem Prozessraum weisendes Fenster zum Durchlassen der Strahlung eine möglichst geringe Temperatur aufweist. Dabei soll bevorzugt auch das Auftreten von einzelnen heißen Stellen (Hotspots) vermieden werden. Der Aufbau soll möglichst einfach, kostengünstig zu realisieren und sicher sein. Des Weiteren sollen möglichst auch Fehlfunktionen wie Lecks oder eine fehlende Kühlwirkung erkannt werden können.

Bei Trocknungsprozessen oder Härtungsprozessen in entzündlichen Atmosphären sollen die Höchsttemperaturen der Oberflächen des Infrarot-Moduls oder UV-Moduls, welche mit dem entzündlichen Gasgemisch in Berührung stehen, den Zündpunkt eben dieses Gasgemisches nicht erreichen sondern vorzugsweise mit einem ausreichenden Abstand unterschreiten.

Das Infrarot-Modul und das UV-Modul soll platzsparend aufgebaut sein und in bestehende Prozesslinien eingebaut werden können, ohne dass ein aufwendiger Umbau der Prozesslinien notwendig wird.

Die Aufgaben der Erfindung werden gelöst durch ein Infrarot-Modul aufweisend zumindest einen Strahler in Form zumindest eines Infrarotstrahlers oder ein UV-Modul aufweisend zumindest einen Strahler in Form zumindest eines UV-Strahlers, das Infrarot-Modul oder UV-Modul aufweisend ein Modulgehäuse mit einem Fenster, wobei das Modulgehäuse den zumindest einen Strahler umhüllt, wobei das Fenster passend zum Strahler aus einem für Infrarotstrahlung eines Wellenlängenbereichs im infraroten Spektrum des Lichts durchlässigen Material oder aus einem für UV-Strahlung eines Wellenlängenbereichs im ultravioletten Spektrum des Lichts durchlässigen Material besteht und der zumindest eine Strahler derart in dem Modulgehäuse angeordnet ist, dass eine von dem zumindest einen Infrarotstrahler abgestrahlte Infrarotstrahlung durch das Fenster aus dem Infrarot-Modul herausstrahlt oder eine von dem zumindest einen UV-Strahler abgestrahlte UV-Strahlung durch das Fenster aus dem UV-Modul herausstrahlt, wobei das Modulgehäuse eine Einlassöffnung zum Zuführen eines Gasstroms in das Modulgehäuse hinein und zumindest eine Ablassöffnung zum Ableiten des Gasstroms aus dem Modulgehäuse heraus aufweist, wobei das Modulgehäuse zumindest eine Leitung zum Leiten des Gasstroms aus der Einlassöffnung über eine innenliegende Oberfläche des Fensters zu der zumindest einen Ablassöffnung aufweist, wobei die innenliegende Oberfläche des Fensters in das Modulgehäuse hinein ausgerichtet ist, wobei das Modulgehäuse eine Gasströmungsaufteilungseinrichtung aufweist, wobei die Gasströmungsaufteilungseinrichtung den Gasstrom aus der Einlassöffnung innerhalb des Modulgehäuses in mehrere Gasströmungen aufteilt und wobei das Modulgehäuse die mehreren Gasströmungen oder einen ersten Anteil der mehreren Gasströmungen derart leitet, dass die mehreren Gasströmungen oder der erste Anteil der mehreren Gasströmungen die innenliegende Oberfläche des Fensters abschnittsweise überspülen.

Das Fenster kann in mehrere Teilfenster aufgeteilt sein, muss also nicht als zusammenhängendes einteiliges Fenster vorliegen. Dementsprechend muss auch die innenliegende Oberfläche des Fensters keine zusammenhängende Oberfläche sein, sondern sie kann in mehrere Teilbereiche unterteilt sein, die auch voneinander räumlich getrennt sein können. Bevorzugt ist das Fenster jedoch einteilig.

Das Fenster ist ein Teil des Modulgehäuses. Bevorzugt ist das Fenster gegen das restliche Modulgehäuse abgedichtet, besonders bevorzugt druckdicht abgedichtet.

Das Modulgehäuse schließt das Infrarot-Modul oder UV-Modul nach außen ab. Insbesondere kann vorgesehen sein, dass das Modulgehäuse mit dem Fenster das Infrarot-Modul oder UV-Modul gasdicht von seiner Umgebung oder einem Prozessraum trennt, in der oder in dem die Infrarotstrahlung oder die UV-Strahlung zum Prozessieren genutzt wird. Hierzu kann insbesondere ein Teil der äußeren Oberfläche des Modulgehäuses, der das Fenster beinhaltet, den zumindest einen Strahler von dem Prozessraum trennen. Hierdurch kann verhindert werden, dass brennbare oder schädliche Gase aus dem Prozessraum bis zu dem zumindest einen Strahler gelangen und sich dort entzünden oder den zumindest einen Strahler beschädigen.

Unter dem Gasstrom ist im Sinne der vorliegenden Patentanmeldung immer der Gasstrom zu verstehen, der durch die Einlassöffnung in das Modulgehäuse strömt. Unter den mehreren Gasströmungen sind im Sinne der vorliegenden Patentanmeldung immer die mehreren Gasströmungen zu verstehen, die durch Aufteilen des Gasstroms aus der Einlassöffnung mit Hilfe der Gasströmungsaufteilungseinrichtung entstehen und die anschließend in der zumindest einen Leitung des Modulgehäuses geleitet werden.

Die mehreren Gasströmungen müssen nach der Gasströmungsaufteilungseinrichtung im Modulgehäuse nicht zwingend getrennt voneinander geleitet werden. Es kann jedoch vorgesehen sein, dass die zumindest eine Leitung im Modulgehäuse derart aufgebaut ist, dass die mehreren Gasströmungen zumindest bereichsweise räumlich voneinander getrennt geführt werden, bevor sie zum Fenster gelangen oder bevor sie durch die zumindest eine Ablassöffnung aus dem UV-Modul heraus geleitet werden. Bevorzugt ist die zumindest eine Leitung im Modulgehäuse jedoch derart gestaltet, dass die mehreren Gasströmungen zumindest im Bereich des Fensters nicht räumlich voneinander getrennt über die innenliegende Oberfläche des Fensters geleitet werden.

Das Infrarot-Modul ist ein Infrarot-Modul zur Abstrahlung von elektromagnetischer Strahlung im Infrarot-Bereich. Das UV-Modul ist ein UV-Modul zur Abstrahlung von elektromagnetischer Strahlung im ultravioletten (UV) Bereich.

Insbesondere ist das Infrarot-Modul zur Abstrahlung von elektromagnetischer Strahlung im

Wellenlängen-Bereich von 780 nm bis 10 µm geeignet, wobei Teilbereiche hiervon ausreichend sind. Bevorzugt kann bei erfindungsgemäßen Infrarot-Modulen elektromagnetische Strahlung in einem Wellenlängen-Bereich von 780 nm bis 4 µm abgegeben werden, besonders bevorzugt in einem Wellenlängen-Bereich von 1000 nm bis 4 µm abgegeben werden. Dementsprechend ist vorzugsweise das Fenster zumindest für einem Teilbereich dieser Wellenlängen-Bereiche durchlässig.

Insbesondere ist das UV-Modul zur Abstrahlung von elektromagnetischer Strahlung im Wellenlängen-Bereich von 100 nm bis 450nm geeignet, wobei Teilbereiche hiervon ausreichend sind. Bevorzugt kann bei erfindungsgemäßen UV-Modulen elektromagnetische Strahlung in einem Wellenlängen-Bereich von 300 nm bis 450 nm abgegeben werden. Dementsprechend ist vorzugsweise das Fenster zumindest für einem Teilbereich dieser Wellenlängen-Bereiche durchlässig.

Es reicht aus, wenn das Fenster aus einem für Infrarotstrahlung eines Wellenlängenbereichs durchlässigen Material oder aus einem für UV-Strahlung eines Wellenlängenbereichs durchlässigen Material besteht. Es ist jedoch bevorzugt, dass das Fenster aus einem für Infrarotstrahlung eines Wellenlängenbereichs transparentem Material oder aus einem für UV-Strahlung eines Wellenlängenbereichs transparentem Material besteht.

Dass das Fenster aus einem für Infrarotstrahlung eines Wellenlängenbereichs im infraroten Spektrum des Lichts durchlässigen Material oder aus einem für UV-Strahlung eines Wellenlängenbereichs im ultravioletten Spektrum des Lichts durchlässigen Material besteht, bedeutet, dass das Material für Infrarotstrahlung in einem Wellenlängenbereich durchlässig ist, wobei dieser Wellenlängenbereich im infraroten Spektrum des Lichts liegt und also ein Teilbereich des gesamten infraroten Spektrums des Lichts ist, oder dass das Material für UV-Strahlung in einem Wellenlängenbereich durchlässig ist, wobei dieser Wellenlängenbereich im ultravioletten Spektrum des Lichts liegt und also ein Teilbereich des gesamten ultravioletten Spektrums des Lichts ist. Im Extremfall kann der Teilbereich des gesamten infraroten Spektrums des Lichts das gesamte infrarote Spektrum sein und der Teilbereich des gesamten ultravioletten Spektrums des Lichts das gesamte ultraviolette Spektrum sein, bevorzugt kann jedoch vorgesehen sein, dass der Teilbereich des gesamten infraroten Spektrums des Lichts nur einen Anteil von maximal 90% der Wellenlängen des gesamten infraroten Spektrums umfasst und der Teilbereich des gesamten ultravioletten Spektrums des Lichts nur einen Anteil von maximal 50% der Wellenlängen des gesamten ultravioletten Spektrums umfasst, der für die UV-Strahlung besonders bevorzugt im Bereich von 280 nm bis 450 nm liegt. Das gesamte infrarote Spektrum des Lichts reicht von einer Wellenlänge von 780 nm bis zu einer Wellenlänge von 1 mm. Das gesamte ultraviolette Spektrum des Lichts reicht von einer Wellenlänge von 100 nm bis zu einer Wellenlänge von 450 mm.

Es ist des Weiteren bevorzugt, dass das Fenster maximal 50% der Intensität von Infrarotstrahlung eines Wellenlängenbereichs absorbiert oder maximal 50% der Intensität von UV-Strahlung eines Wellenlängenbereichs absorbiert, bevorzugt das Fenster maximal 30% der Intensität von Infrarotstrahlung eines Wellenlängenbereichs absorbiert oder maximal 30% der Intensität von UV-Strahlung eines Wellenlängenbereichs absorbiert, besonders bevorzugt das Fenster maximal 10% der Intensität von Infrarotstrahlung eines Wellenlängenbereichs absorbiert oder maximal 10% der Intensität von UV-Strahlung eines Wellenlängenbereichs absorbiert.

Das Modulgehäuse kann bis auf das Fenster aus Metall gefertigt sein, bevorzugt aus Metallblechen oder zumindest teilweise aus einem Strangpressprofil.

Die Einlassöffnung und die Ablassöffnung sind vorzugsweise austauschbar, so dass die Einlassöffnung als Ablassöffnung und die Ablassöffnung als Einlassöffnung verwendet werden kann.

Es kann vorgesehen sein, dass der innere Aufbau des Modulgehäuses hinsichtlich der zumindest einen Leitung und der Gasströmungsaufteilungseinrichtung entlang einer Längsachse des Fensters und/oder des zumindest einen Strahlers spiegelbildlich oder symmetrisch aufgebaut ist. Hierdurch kann das Infrarot-Modul oder UV-Modul auch umgekehrt angeschlossen werden. Zudem sind so gleichmäßige Gasströmungen in Querrichtung zur Längsachse des Fensters beziehungsweise des zumindest einen Strahlers möglich.

Es kann vorgesehen sein, dass die mehreren Gasströmungen oder der erste Anteil der mehreren Gasströmungen die innenliegende Oberfläche des Fensters in zumindest 70% der gesamten innenliegenden Oberfläche des Fensters überspülen oder die innenliegende Oberfläche des Fensters vollständig überspülen, bevorzugt die mehreren Gasströmungen oder der erste Anteil der mehreren Gasströmungen die innenliegende Oberfläche des Fensters in zumindest 90% der gesamten innenliegenden Oberfläche des Fensters überspülen oder die innenliegende Oberfläche des Fensters vollständig überspülen.

Hierdurch kann eine effiziente und gleichmäßige Kühlung des Fensters mit den mehreren Gasströmungen oder dem ersten Anteil der mehreren Gasströmungen sichergestellt werden. Des Weiteren kann vorgesehen sein, dass das Modulgehäuse die mehreren Gasströmungen oder einen zweiten Anteil der mehreren Gasströmungen derart über den zumindest einen Strahler führt, dass die mehreren Gasströmungen oder der zweite Anteil der mehreren Gasströmungen eine äußere Oberfläche des zumindest einen Strahlers abschnittsweise überspülen.

Hierdurch kann auch eine Kühlung der äußeren Oberfläche des zumindest einen Strahlers erreicht werden, insbesondere eines äußeren Hüllrohrs eines Infrarotstrahlers erreicht werden, was zu einer Kühlwirkung des gesamten Infrarot-Moduls oder UV-Moduls führt. Das Modulgehäuse teilt hierzu mit Hilfe der Gasströmungsaufteilungseinrichtung den Gasstrom in die entsprechenden Gasströmungen auf. Die Gasströmungsaufteilungseinrichtung hat einen Anteil an der Führung der Gaströmungen.

Ferner kann vorgesehen sein, dass das Fenster einen Teil der Außenwand des Modulgehäuses begrenzt, bevorzugt das Fenster einen Teil der Außenwand des Modulgehäuses auf einer Seite des Modulgehäuses begrenzt, besonders bevorzugt das Fenster einen Teil der Außenwand des Modulgehäuses auf einer Unterseite der Modulgehäuses begrenzt.

Hierdurch kann das Infrarot-Modul oder UV-Modul bequem und einfach in eine Bearbeitungsanlage integriert werden, die die Infrarotstrahlung oder UV-Strahlung nutzt. Hierbei kann bevorzugt vorgesehen sein, dass das Fenster mit angrenzenden äußeren Wandungen des Modulgehäuses gasdicht oder druckdicht verbunden ist.

Es kann auch vorgesehen sein, dass der zumindest eine Strahler derart im Modulgehäuse angeordnet ist, dass die von dem zumindest einen Strahler abgestrahlte Infrarotstrahlung oder UV-Strahlung mit einem Anteil von zumindest 10 % der gesamten Strahlungsleistung der Infrarotstrahlung oder der UV-Strahlung des zumindest einen Strahlers durch das Fenster aus dem Infrarot-Modul oder UV-Modul abstrahlt, bevorzugt mit einem Anteil von zumindest 20 % der gesamten Strahlungsleistung der Infrarotstrahlung oder der UV-Strahlung des zumindest einen Strahlers durch das Fenster aus dem Infrarot-Modul oder UV-Modul abstrahlt, besonders bevorzugt mit einem Anteil von zumindest 40 % der gesamten Strahlungsleistung der Infrarotstrahlung oder der UV-Strahlung des zumindest einen Strahlers durch das Fenster aus dem Infrarot-Modul oder UV-Modul abstrahlt, ganz besonders bevorzugt mit einem Anteil von zumindest 60 % der gesamten Strahlungsleistung der Infrarotstrahlung oder der UV-Strahlung des zumindest einen Strahlers durch das Fenster aus dem Infrarot-Modul oder UV-Modul abstrahlt.

Hierfür können zur Unterstützung der Lichtausbeute der Infrarotstrahlung oder der UV-Strahlung auch Reflektoren verwendet und in dem Infrarot-Modul oder UV-Modul angeordnet werden.

Durch diese Anteile wird sichergestellt, dass das Infrarot-Modul oder UV-Modul effizient und mit einem hohen Wirkungsgrad arbeiten kann.

Es kann ferner vorgesehen sein, dass der zumindest eine Strahler derart im Modulgehäuse angeordnet ist, dass der zumindest eine Strahler einen Abstand von höchstens 20 cm zu dem Fenster aufweist, wobei vorzugsweise das Fenster und der zumindest eine Strahler eine langestreckte Form aufweisen und der zumindest eine Strahler passend zu dem Fenster ausgerichtet ist. Passend zu dem Fenster ausgerichtet, bedeutet, dass die langen Achsen des zumindest einen Strahlers und des Fensters einen Winkel von maximal 10° zueinander aufweisen, bevorzugt einen Winkel von maximal 5° zueinander aufweisen, besonders bevorzugt in etwa parallel zueinander sind, so dass sie einen Winkel von maximal 1° zueinander aufweisen. Es kann auch vorgesehen sein, dass das Fenster mindestens 90% so lang ist wie der zumindest eine Strahler.

Gemäß einer bevorzugten Weiterbildung der vorliegenden Erfindung kann vorgesehen sein, dass innerhalb des Modulgehäuses zumindest ein Reflektor angeordnet ist, wobei mit dem zumindest einen Reflektor ein Teil der von dem zumindest einen Strahler abgestrahlten Infrarotstrahlung oder der UV-Strahlung durch das Fenster aus dem Infrarot-Modul oder UV-Modul heraus-reflektierbar ist, wobei bevorzugt der zumindest eine Reflektor eine metallische oder metallisierte Reflektor-Oberfläche zum Reflektieren des Teils der von dem zumindest einen Strahler abgestrahlten Infrarotstrahlung oder der UV-Strahlung durch das Fenster aufweist, besonders bevorzugt eine mit SiO2, mit Gold beschichtete und/oder metallisierte Reflektor-Oberfläche aufweist.

Zu diesem Zweck kann der zumindest eine Reflektor unmittelbar neben dem zumindest einen Strahler oder bereichsweise um eine längliche Außenkontur des zumindest einen Strahlers herum angeordnet sein.

Bevorzugt kann vorgesehen sein, dass mit dem zumindest einen Reflektor ein Teil der von dem zumindest einen Strahler nicht direkt durch das Fenster abgestrahlten Infrarotstrahlung oder der UV-Strahlung durch das Fenster reflektierbar ist.

Mit diesen Maßnahmen lässt sich die Lichtausbeute an Infrarotstrahlung oder der UV-Strahlung des Infrarot- oder UV-Moduls vergrößern.

Dabei kann vorgesehen sein, dass in dem zumindest einen Reflektor Öffnungen zum Durchleiten der mehreren Gasströmungen oder zum Durchleiten von einem dritten Anteil der mehreren Gasströmungen angeordnet sind, so dass die mehreren Gasströmungen oder der dritte Anteil der Gasströmungen den zumindest einen Reflektor abschnittsweise überspülen, insbesondere eine Reflektor-Oberfläche des zumindest einen Reflektors überspülen.

Beim Überspülen des zumindest einen Reflektors wird insbesondere die in Richtung des zumindest einen Strahlers weisende Reflektor-Oberfläche mit den mehreren Gasströmungen oder dem dritten Anteil der Gasströmungen abschnittsweise überspült.

Der dritte Anteil der mehreren Gasströmungen und der zuvor erwähnte zweite Anteil der mehreren Gasströmungen, die die äußere Oberfläche des zumindest einen Strahlers außen überspülen, können teilweise oder sogar vollständig identisch sein. Ebenso können sowohl beim zweiten Anteil der mehreren Gasströmungen als auch beim dritten Anteil der mehreren Gasströmungen einzelne Gasströmungen des ersten Anteils der mehreren Gasströmungen umfassen, die das Fenster überspülen.

Auf diese Weise kann auch der zumindest eine Reflektor gekühlt und gleichmäßig temperiert werden und so eine gleichförmige und verringerte Temperatur in dem Modulgehäuse erzielt werden.

Auch kann vorgesehen sein, dass die Gasströmungsaufteilungseinrichtung den Gasstrom aus der Einlassöffnung in mehrere Gasströmungen mit derart gleichgroßen Volumenströmen aufteilt oder in mehrere Anteile von Gasströmungen mit jeweils derart gleichgroßen Volumenströmen aufteilt, dass keiner der Volumenströme der mehreren Gasströmungen oder der Anteile der mehreren Gasströmungen mehr als doppelt so groß ist wie der kleinste Volumenstrom der mehreren Gasströmungen oder der Anteile der mehreren Gasströmungen. Es kann auch vorgesehen sein, dass die Gasströmungsaufteilungseinrichtung den Gasstrom aus der Einlassöffnung in mehrere Gasströmungen mit Strömungsgeschwindigkeiten zwischen 0,5 m/s und 20 m/s aufteilt oder in mehrere Anteile von Gasströmungen mit Strömungsgeschwindigkeiten zwischen 0,5 m/s und 20 m/s aufteilt, wobei vorzugsweise keine der Strömungsgeschwindigkeiten der mehreren Gasströmungen oder der Anteile der mehreren Gasströmungen mehr als doppelt so groß ist wie die kleinste Strömungsgeschwindigkeit der mehreren Gasströmungen oder der Anteile der mehreren Gasströmungen.

Hierdurch kann eine besonders gleichmäßige Kühlung der Abschnitte des Fensters (und optional auch der äußeren Oberfläche des zumindest einen Strahlers und/oder des zumindest einen Reflektors) gewährleistet werden und die Abschnitte können etwa gleich groß gewählt werden.

Es kann dabei vorgesehen sein, dass im Modulgehäuse zusätzlich zu den mehreren Gasströmungen noch ein oder zwei oder auch mehrere zusätzliche Gasströmungen mit kleinerem Volumenstrom aus dem Gasstrom aus der Einlassöffnung abgezweigt werden, um elektrische Anschlüsse des zumindest einen Strahlers zu kühlen oder andere Funktionen zu erfüllen.

Des Weiteren kann vorgesehen sein, dass die Gasströmungsaufteilungseinrichtung in der zumindest einen Leitung zum Leiten des Gasstroms aus der Einlassöffnung zumindest eine Lochplatte mit mehreren Löchern zum Aufteilen des Gasstroms aus der Einlassöffnung aufweist, wobei bevorzugt bei wenigstens einer der zumindest einen Lochplatte die freie Querschnittsfläche der Löcher mit dem Abstand zur Einlassöffnung in der zumindest einen Leitung variiert und/oder bevorzugt mehrere Lochplatten in der zumindest einen Leitung in Strömungsrichtung der mehreren Gasströmungen nacheinander liegend angeordnet sind, wobei besonders bevorzugt dazwischen getrennte Teilleitungen angeordnet sind, die die mehreren Gasströmungen zumindest bereichsweise leiten.

Mit Hilfe der zumindest einen Lochplatte kann die Aufteilung des Gasstroms aus der Einlassöffnung erfolgen und dabei der Volumenstrom der mehreren Gasströmungen auf einfache Weise eingestellt werden. Durch die wachsende freie Querschnittsfläche der Löcher mit wachsendem Abstand zur Einlassöffnung in der zumindest einen Leitung kann der Druckabfall, der an jedem der Löcher auftritt, kompensiert werden und können so mit der wenigstens einen der zumindest einen Lochplatte trotz nachlassendem Gasdruck die mehreren Gasströmungen mit gleichgroßen oder in etwa gleichgroßen Volumenströmen erzeugt werden. Die genaue Ausgestaltung der freien Querschnitte und der geometrischen Form der Löcher kann dabei von dem Volumenstrom des Gasstroms von der Einlassöffnung und der Form der zumindest einen Leitung bis zur zumindest einen Lochplatte sowie dem Strömungswiderstand in der zumindest einen Leitung vor und nach der zumindest einen Lochplatte abhängen. Die gewünschten Volumenströme der mehreren Gasströmungen können mit Hilfe einer Simulation berechnet werden oder experimentell bestimmt werden, wobei bei der experimentellen Bestimmung die Kühlleistung an den Abschnitten des Fensters und gegebenenfalls an weiteren zu kühlenden Oberflächen als Versuchsparameter verwendet werden kann, um eine optimierte Geometrie und Form der zumindest einen Lochplatte zu ermitteln. Auf die gleiche Weise kann auch die geometrische Form anderer Teile der zumindest einen Leitung und der Gasströmungsaufteilungseinrichtung des Modulgehäuses optimiert werden, auch wenn keine Lochplatte vorhanden ist.

Die freie Querschnittsfläche der Löcher der zumindest einen Lochplatte ist die Fläche der Löcher, die nicht durch andere Teile derart verdeckt oder blockiert werden, dass die Gasströmung durch diese Bereiche verhindert oder zu einem Großteil (also zu mehr als 50%) verringert wird.

Es kann auch vorgesehen sein, dass die Gasströmungsaufteilungseinrichtung in der zumindest einen Leitung zum Leiten des Gasstroms aus der Einlassöffnung zumindest eine Trennwand aufweist, wobei die zumindest eine Trennwand den Gasstrom aus der Einlassöffnung aufteilt und in zumindest zwei Teilleitungen leitet, die zu unterschiedlichen Abschnitten des Fensters führen, wobei bevorzugt die zumindest eine Trennwand unmittelbar an der Einlassöffnung beginnt.

Hierdurch kann ein besonders einfacher und kostengünstiger Aufbau des Modulgehäuses gewählt werden, der insbesondere für die Aufteilung des Gasstroms in nur wenige mehrere Gasströmungen (z.B. bis zu zehn Gasströmungen) geeignet und bevorzugt wird. Dass die zumindest eine Trennwand unmittelbar an der Einlassöffnung beginnt kann bevorzugt bedeuten, dass eine Beabstandung von maximal 10 cm zu der Einlassöffnung realisiert ist. Ferner kann vorgesehen sein, dass in der Einlassöffnung oder vor der Einlassöffnung oder in der zumindest einen Leitung vor dem Fenster ein Filter zum Filtern des Gasstroms und/oder eine Reinigungseinrichtung zur Reinigung des Gasstroms von unerwünschten Substanzen angeordnet ist.

Hierdurch kann verhindert werden, dass unerwünschte Substanzen oder Partikel das Fenster oder den zumindest einen Strahler beeinträchtigen oder das Infrarot-Modul oder UV-Modul beschädigen oder dessen Betrieb stören können.

Des Weiteren kann vorgesehen sein, dass in der zumindest einen Leitung zumindest ein Drucksensor zum Bestimmen des Gasdrucks in der zumindest einen Leitung angeordnet ist und/oder an dem Fenster zumindest ein Bruchsensor zum Erkennen eines Bruchs des Fensters angeordnet ist und/oder an einem Teil des Modulgehäuses zumindest ein Temperatursensor zum Bestimmen der Temperatur wenigstens einer Oberfläche oder eines Teils des Modulgehäuses angeordnet ist, wobei bevorzugt das Infrarot-Modul oder UV-Modul eine Steuerung zur Auswertung der Messsignale des zumindest einen Drucksensors und/oder des zumindest einen Bruchsensors und/oder des zumindest einen Temperatursensors aufweist, wobei besonders bevorzugt die Steuerung den Volumenstrom des Gasstroms aus der Einlassöffnung aufgrund der Messung des zumindest einen Temperatursensors steuert und/oder die Steuerung bei einem unerwarteten Druckabfall und/oder bei einer Erkennung eines Bruchs des Fensters und/oder bei einem unerwarteten Temperaturanstieg ein Signal abgibt, ganz besonders bevorzugt ein Alarm-Signal und/oder ein Signal zum Unterbrechen des Betriebs des zumindest einen Strahlers und/oder einer Trocknungsanlage oder Härtungsanlage, in der das Infrarot-Modul oder UV-Modul eingebaut ist.

Hierdurch können gefährliche Betriebsarten des Infrarot-Moduls oder UV-Moduls aufgrund von, von außen in das Infrarot-Modul oder UV-Modul zu dem zumindest einen Strahler eindringenden Gasen verhindert werden.

Auch kann vorgesehen sein, dass das Infrarot-Modul oder UV-Modul ein Gebläse zum Antreiben des Gasstroms aufweist, wobei bevorzugt das Gebläse steuerbar ist, besonders bevorzugt von der Steuerung des Infrarot- oder UV-Moduls steuerbar ist.

Alternativ kann vorgesehen sein, dass das Infrarot-Modul oder UV-Modul eine Gasstrom-Regulierungs-Vorrichtung aufweist, mit der ein von außen zugeführter Gasstrom regulierbar ist. Hierdurch wird das Infrarot-Modul oder UV-Modul weiter komplettiert und es ergeben sich weitere Möglichkeiten zur Steuerung des Betriebs des Infrarot- oder UV-Moduls.

Mit einer Weiterbildung der vorliegenden Erfindung wird auch vorgeschlagen, dass jeder der zumindest einen Infrarotstrahler ein Heizelement und ein Hüllrohr aufweist, wobei das Hüllrohr das Heizelement außen umschließt und das Hüllrohr zumindest bereichsweise oder vollständig für Infrarotstrahlung eines Wellenlängenbereichs durchlässig ist, oder der zumindest eine Infrarotstrahler ein Keramikstrahler ist.

Diese Infrarotstrahler sind zur Herstellung eines Infrarot-Moduls zum Trocknen von Slurrys besonders gut geeignet, das gilt insbesondere für die Infrarotstrahler mit Heizelement und Hüllrohr. Das Heizelement wird vorzugsweise elektrisch betrieben und besteht bevorzugt aus Wendeln oder einem Geflecht aus Karbon, Siliziumcarbid oder aus einer hochtemperaturfesten metallischen Legierung, wie sie beispielsweise unter dem Namen Kanthal^{®} vertrieben werden. Der zumindest eine UV-Strahler eines UV-Moduls kann vorzugsweise durch Mitteldruck- oder Niederdruck Quecksilber-/Amalgam-Strahler, Excimer-Strahler oder UV-LEDs realisiert werden. UV-LEDs brauchen meist eine Kühlung des Substrats, die erfindungsgemäße bevorzugt durch die mehreren Gasströmungen oder einen vierten Anteil der mehreren Gasströmungen erzielt oder zumindest unterstützt werden kann. Eine solche Kühlung durch die mehreren Gasströmungen oder den vierten Anteil der mehreren Gasströmungen kann bodenseitig an den UV-LEDs angeordneten Kühlkörpern erfolgen.

Es kann vorgesehen sein, dass das Fenster eine langgestreckte Geometrie mit zwei einander gegenüberliegend angeordneten langen Seiten hat, wobei die mehreren Gasströmungen die innenliegende Oberfläche des Fensters von einer der langen Seite des Fensters bis zu der gegenüberliegend angeordneten langen Seite des Fensters abschnittsweise überspülen, wobei das Fenster vorzugsweise eine rechteckige Geometrie hat.

Es kann auch vorgesehen sein, dass die mehreren Gasströmungen die innenliegende Oberfläche des Fensters quer zu einer Längsrichtung des Fensters überspülen, wobei bevorzugt die mehreren Gasströmungen die innenliegende Oberfläche des Fensters in einem Winkel von 20° bis 90° zu der Längsrichtung des Fensters überspülen, besonders bevorzugt die mehreren Gasströmungen die innenliegende Oberfläche des Fensters in einem Winkel von 45° bis 90° zu der Längsrichtung des Fensters überspülen, ganz besonders bevorzugt die mehreren Gasströmungen die innenliegende Oberfläche des Fensters in einem Winkel von 80° bis 90° zu der Längsrichtung des Fensters überspülen.

Hierdurch wird sichergestellt, dass das Fenster möglichst gleichmäßig gekühlt wird und keine Hotspots am Fenster entstehen.

Des Weiteren kann vorgesehen sein, dass das Fenster aus Quarzglas besteht.

Ferner kann vorgesehen sein, dass der zumindest eine Infrarotstrahler ein Carbon-Heizelement, ein Siliziumcarbid-Heizelement oder ein aus einem hochtemperaturstabilen Metall bestehendes Heizelement aufweist oder der zumindest eine UV-Strahler mehrere UV-LEDs oder einen Quecksilber-Strahler, einen Amalgam-Strahler oder einen Excimer-Strahler aufweist. Das Quarzglas ist für Infrarotstrahlung und UV-Strahlung durchlässig und gleichzeitig auch bei hohen Temperaturen stabil sowie gegen chemische Einflüsse resistent. Die Materialien und Bauteile für den zumindest einen Strahler sind für das Infrarot-Modul beziehungsweise das UV-Modul gut geeignet und lassen sich kostengünstig verbauen.

Des Weiteren kann auch vorgesehen sein, dass die zumindest eine Leitung und die Gasströmungsaufteilungseinrichtung des Modulgehäuses den Gasstrom und die mehreren Gasströme derart leitet, dass diese nicht mehrfach nacheinander über eine sich im Betrieb des Infrarot-Moduls oder UV-Moduls erhitzende Oberfläche des Infrarot-Moduls oder UV-Moduls geleitet werden, bevorzugt die zumindest eine Leitung und die Gasströmungsaufteilungseinrichtung des Modulgehäuses den Gasstrom und die mehreren Gasströme derart leiten, dass die mehreren Gasströme nur einmal über eine sich im Betrieb des Infrarot-Moduls oder UV-Moduls erhitzende Oberfläche des Infrarot-Moduls oder UV-Moduls geleitet werden, besonders bevorzugt die zumindest eine Leitung und die Gasströmungsaufteilungseinrichtung des Modulgehäuses den Gasstrom und die mehreren Gasströme derart leiten, dass die mehreren Gasströme nur einmal über eines der Bauteile der Gruppe bestehend aus dem Fenster, dem zumindest einen Strahler und dem zumindest eine Reflektor geleitet werden.

Hierdurch wird eine gleichmäßige Kühlung der zu kühlenden Teile des Infrarot-Moduls oder UV-Moduls erreicht.

Die der vorliegenden Erfindung zugrundeliegenden Aufgaben werden auch gelöst durch eine Bearbeitungsanlage zur Veränderung eines Stoffs mittels Infrarotstrahlung oder UV-Strahlung, die Bearbeitungsanlage aufweisend zumindest ein Infrarot-Modul oder UV-Modul wie zuvor beschrieben, wobei die Bearbeitungsanlage zumindest eine Halterung zum Anordnen eines zu verändernden Stoffs und/oder eine Fördereinrichtung zum Fördern des zu verändernden Stoffs, insbesondere eines Drahts oder Bands, in einem Lichtkegel der aus dem Fenster des zumindest einen Infrarot-Moduls oder UV-Moduls austretenden Infrarotstrahlung oder UV-Strahlung aufweist, wobei vorzugsweise die Bearbeitungsanlage einen Prozessraum aufweist, der durch zumindest einen Teil des Modulgehäuses und durch das Fenster von einem Innenraum des Modulgehäuses getrennt ist, besonders bevorzugt gasdicht und/oder druckdicht getrennt ist.

Die Bearbeitungsanlage weist die Vorteile des erfindungsgemäßen Infrarot-Moduls oder UV-Moduls auf.

Die Bearbeitungsanlage ist vorzugsweise eine Trocknungsanlage, kann aber auch eine Härtungsanlage, eine Reinigungsanlage oder eine Entkeimungsanlage sein.

Bei erfindungsgemäßen Bearbeitungsanlagen können in dem Prozessraum entzündliche oder explosive Substanzen enthalten sein oder während des Betriebs entzündliche oder explosive Substanzen im Prozessraum entstehen. Durch die erfindungsgemäßen Infrarot-Module und UV-Module gelingt es, die dadurch möglicherweise auftretenden Gefahren zu reduzieren.

Die der vorliegenden Erfindung zugrundeliegenden Aufgaben werden auch gelöst durch ein Verfahren zum Betreiben eines Infrarot-Moduls oder UV-Moduls wie zuvor beschrieben oder einer Bearbeitungsanlage wie zuvor beschrieben, gekennzeichnet durch die Schritte:
A) Einspeisen eines Gasstroms durch die Einlassöffnung in das Modulgehäuse;
B) Teilen des Gasstroms in mehrere Gasströmungen;
C) Überspülen von Abschnitten der innenliegenden Oberfläche des Fensters des Modulgehäuses mit den mehreren Gasströmungen und dadurch Kühlen des Fensters mit den mehreren Gasströmungen; und
D) Ableiten der mehreren Gasströmungen aus dem Modulgehäuse heraus;
wobei während der Schritte A) bis D) Infrarotstrahlung oder UV-Strahlung mit dem zumindest einen Strahler erzeugt wird und durch das Fenster aus dem Infrarot-Modul oder UV-Modul abgestrahlt wird.

Bevorzugt wird in dem aus dem Fenster des Infrarot-Moduls oder UV-Moduls abgestrahlten Infrarotstrahlung oder UV-Strahlung ein Objekt getrocknet, gehärtet oder bestrahlt.

Bei erfindungsgemäßen Verfahren kann vorgesehen sein, dass während des Verfahrens eine Temperatur im Modulgehäuse und/oder der Druck des Gases an zumindest einer Stelle der zumindest einen Leitung und/oder das Vorliegen eines Bruchs des Fensters gemessen wird, wobei bevorzugt das Erzeugen von Infrarotstrahlung oder von UV-Strahlung mit dem zumindest einen Strahler unterbrochen wird, wenn ein Temperaturabfall, ein Druckabfall und/oder ein Bruch des Fensters detektiert wird, und/oder der Volumenstrom des Gasstroms durch die Einlassöffnung in das Modulgehäuse unterbrochen oder gesteuert wird, wenn eine Temperaturänderung, eine Druckänderung und/oder ein Bruch des Fensters detektiert wird. Hierdurch kann der Betrieb des Infrarot-Moduls oder UV-Moduls gesteuert und geregelt werden und auf Störungen im Betrieb reagiert werden.

Es kann auch vorgesehen sein, dass das Verfahren mit einem Überdruck im Inneren des Modulgehäuses gegenüber einem Druck auf einer der innenliegenden Seite des Fensters gegenüberliegenden Außenseite des Fensters durchgeführt wird, insbesondere gegenüber einem Druck in einem Prozessraum durchgeführt wird, wobei vorzugsweise bei einem Leck oder einem Bruch des Modulgehäuses Gas aus dem Inneren des Modulgehäuses in die Umgebung des Modulgehäuses oder in den Prozessraum strömt.

Hierdurch wird sichergestellt, dass im Falle eines Fensterbruchs oder anders gearteten Lecks keine entzündlichen Substanzen in das Infrarot-Modul oder UV-Modul gelangen und sich am zumindest einen Strahler entzünden können.

Ferner kann vorgesehen sein, dass in Schritt A) der Gasstrom gefiltert und/oder gereinigt wird, bevor er in die mehreren Gasströmungen geteilt wird.

Hierdurch kann verhindert werden, dass unerwünschte Substanzen oder Partikel das Fenster oder den zumindest einen Strahler beeinträchtigen oder das Infrarot-Modul oder UV-Modul beschädigen oder dessen Betrieb stören können.

Des Weiteren kann vorgesehen sein, dass ein Teil der von dem zumindest einen Strahler ausgehenden Infrarotstrahlung oder UV-Strahlung von einer die Infrarotstrahlung oder die UV-Strahlung reflektierenden Oberfläche eines Reflektors durch das Fenster reflektiert wird, wobei die mehreren Gasströmungen in Schritt C) die Infrarotstrahlung oder UV-Strahlung reflektierende Oberfläche des Reflektors abschnittsweise überspülen und dadurch kühlen.

Mit diesen Maßnahmen lässt sich die Lichtausbeute an Infrarotstrahlung oder UV-Strahlung des Infrarot- oder UV-Moduls vergrößern.

Es kann auch vorgesehen sein, dass in Schritt C) ein Überspülen von Abschnitten von äußeren Oberflächen des zumindest einen Strahlers mit den mehreren Gasströmungen erfolgt und dadurch ein Kühlen der Oberfläche des Strahlers mit den mehreren Gasströmungen erfolgt. Hierdurch kann auch eine Kühlung des zumindest einen Strahlers erreicht werden, was zu einer Kühlwirkung des gesamten Infrarot- oder UV-Moduls führt.

Ferner kann vorgesehen sein, dass die mehreren Gasströmungen vor dem Überspülen der Abschnitte der innenliegenden Oberfläche des Fensters des Modulgehäuses in Schritt C) einen Temperaturunterschied von maximal 10 °C haben, bevorzugt mit einer Genauigkeit von 1 °C die gleiche Temperatur haben.

Hierdurch wird eine gleichmäßige Kühlung der verschiedenen Abschnitte des Fensters erreicht. Zu dem gleichen Zweck kann auch vorgesehen sein, dass die Volumenströme der mehreren Gasströmungen beim Überspülen der Abschnitte der innenliegenden Oberfläche des Fensters des Modulgehäuses in Schritt C) in etwa gleich groß sind, sich also um weniger als 50% unterscheiden.

Zu dem gleichen Zweck kann ferner vorgesehen sein, dass die Abschnitte der innenliegenden Oberfläche des Fensters des Modulgehäuses in etwa gleich groß sind.

Der Erfindung liegt die überraschende Erkenntnis zugrunde, dass es durch eine Aufteilung einer Gasströmung in einem Modulgehäuse eines Infrarot-Moduls oder UV-Moduls in mehrere Gasströmungen gelingt, ein abschnittsweises Überspülen eines IR- oder UV-durchlässigen Fensters zu erreichen und dadurch eine gute und zudem gleichmäßigere Kühlwirkung auf das Fenster zu bewirken, als bei herkömmlichen Infrarot-Modulen oder UV-Modulen. Durch diese Maßnahme gelingt es, eine homogenere und effizientere Kühlung des Fensters und gegebenenfalls weiterer Teile des Infrarot-Moduls oder UV-Moduls, wie beispielsweise des zumindest einen Strahlers und insbesondere eines äußeren Hüllrohrs des zumindest einen Infrarotstrahlers und/oder zumindest eines Reflektors für Infrarotlicht oder UV-Licht, zu erreichen. Im Gegensatz zu einer Kühlung entlang der Länge der Strahler beziehungsweise eines Hüllrohrs des Infrarotstrahlers, wie im Stand der Technik beschrieben, findet eine homogenere und effizientere Kühlung über die Gesamtlänge des zumindest einen Strahlers beziehungsweise des Infrarot-Moduls oder UV-Moduls statt. Dadurch kann sichergestellt werden, dass das Infrarot-Modul oder das UV-Modul beziehungsweise das diesbezüglich besonders kritisch anzusehende Fenster auf seiner gesamten Länge die zulässige Höchsttemperatur nicht überschreitet.

Im Folgenden werden Ausführungsbeispiele der Erfindung anhand von zehn schematisch dargestellten Figuren erläutert, ohne jedoch dabei die Erfindung zu beschränken. Dabei zeigt
Figur 1: eine schematische horizontale Querschnittansicht eines ersten erfindungsgemäßen Infrarot-Moduls von unten aus Richtung eines Fensters des Infrarot-Moduls gesehen;
Figur 2: eine schematische vertikale, in Querrichtung geschnittene Querschnittansicht des ersten erfindungsgemäßen Infrarot-Moduls nach Figur 1;
Figur 3: eine schematische perspektivische Ansicht auf die Oberseite des ersten erfindungsgemäßen Infrarot-Moduls nach den Figuren 1 und 2;
Figur 4: eine schematische perspektivische Ansicht auf die Unterseite mit dem Fenster des ersten erfindungsgemäßen Infrarot-Moduls nach den Figuren 1 bis 3;
Figur 5: eine schematische horizontale Querschnittansicht eines zweiten erfindungsgemäßen Infrarot-Moduls von oben in Richtung eines Fensters des Infrarot-Moduls gesehen;
Figur 6: eine schematische vertikale, in Querrichtung geschnittene Querschnittansicht des zweiten erfindungsgemäßen Infrarot-Moduls nach Figur 5;
Figur 7: eine schematische perspektivische Querschnittansicht auf die Oberseite des zweiten erfindungsgemäßen Infrarot-Moduls nach den Figuren 5 und 6;
Figur 8: eine schematische horizontale transparente Querschnittansicht des zweiten erfindungsgemäßen Infrarot-Moduls von oben aus Richtung des Fensters gesehen;
Figur 9: eine schematische horizontale Querschnittansicht eines dritten erfindungsgemäßen Infrarot-Moduls oder UV-Moduls von oben aus Richtung eines (nicht sichtbaren) Strahlers des Infrarot-Moduls oder UV-Moduls gesehen; und
Figur 10: eine schematische vertikale Querschnittansicht einer erfindungsgemäßen Bearbeitungsanlage zur Veränderung eines Stoffs mittels Infrarotstrahlung oder UV-Strahlung enthaltend sechs erfindungsgemäße Infrarot-Module oder UV-Module.

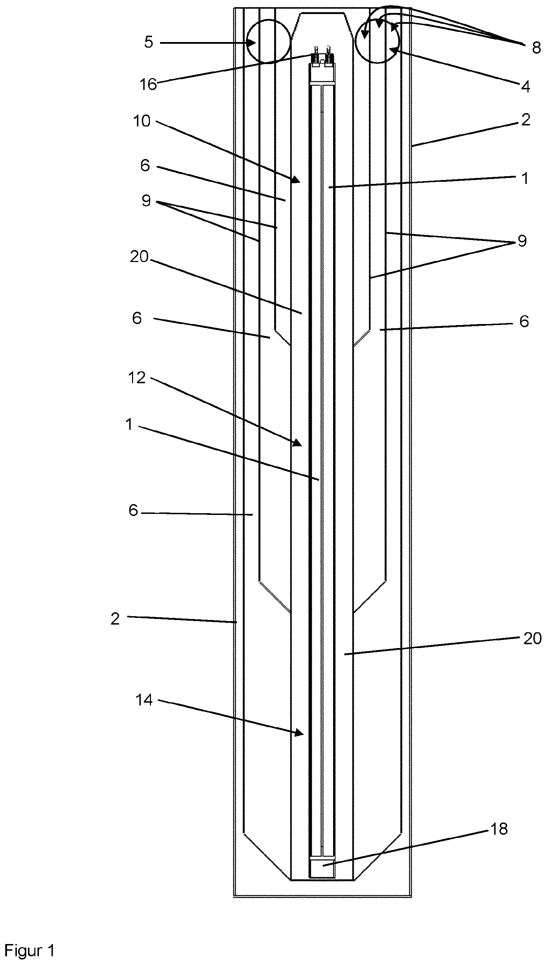

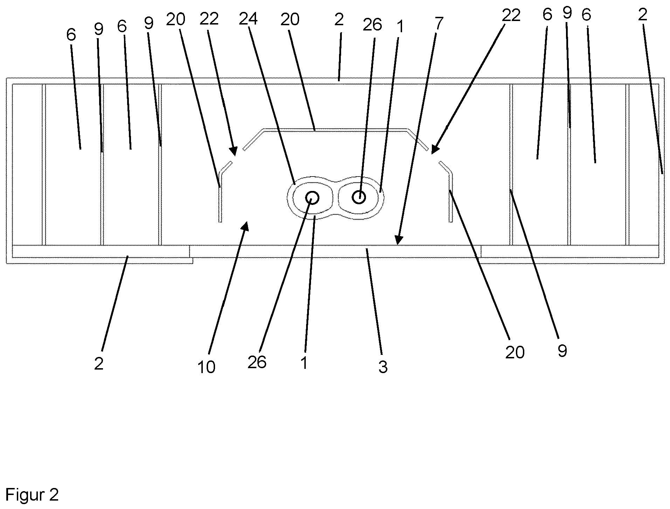

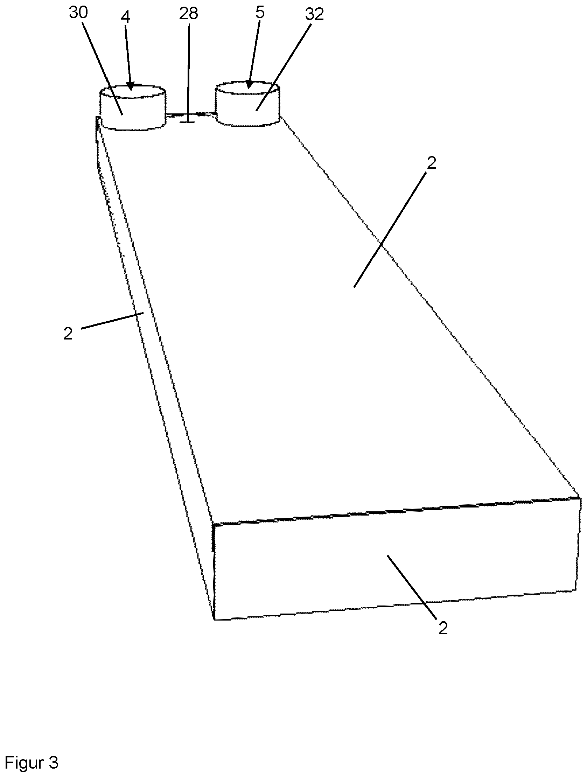

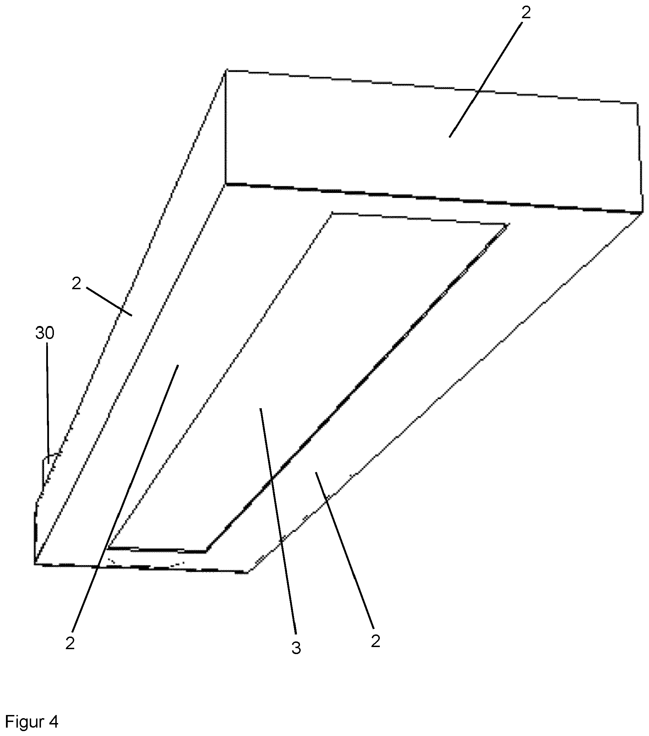

Die Figuren 1 bis 4 zeigen schematischen Ansichten eines ersten erfindungsgemäßen Infrarot-Moduls. Das Infrarot-Modul kann einen Strahler 1 als Infrarot-Quelle aufweisen. Es kann sich hier um einen Zwillingsrohrstrahler handeln, also ein Strahler mit zwei parallel angeordneten Heizelementen, die in Reihe geschaltet sind. Der Strahler 1 kann bevorzugt ein Kurzwellen- oder Karbon-Strahler sein. Der Strahler 1 ist in einem Modulgehäuse 2 mit einem Fenster 3 angeordnet. Das Modulgehäuse 2 kann aus Metallblechen und einem Quarzfenster als das Fenster 3 aufgebaut sein. Das Fenster 3 ist zumindest für einen Wellenlängenbereich im infraroten Wellenlängenspektrum transparent und ist vorzugsweise eine Quarzglasplatte. Das Fenster 3 kann eine rechteckige Form mit einer langen Längsachse und einer kurzen Seite in Querrichtung senkrecht dazu aufweisen. An dem Modulgehäuse 2 ist eine Einlassöffnung 4 zum Einleiten eines Gasstroms in das Modulgehäuse 2 und eine Ablassöffnung 5 zum Ableiten eines Gasstroms aus dem Modulgehäuse 2 angeordnet. Im Inneren des Modulgehäuses 2 sind Leitungen 6 zum Leiten des Gasstroms von der Einlassöffnung 4 zur Ablassöffnung 5 vorgesehen, wobei der Gasstrom über eine innenliegende Oberfläche 7 des Fensters 3 geleitet wird.

Zum Leiten des Gasstroms weist das Infrarot-Modul im Inneren des Modulgehäuses 2 erfindungsgemäß eine Gasströmungsaufteilungseinrichtung 8 auf. Diese Gasströmungsaufteilungseinrichtung 8 kann durch eine Mehrzahl von Trennwänden 9 realisiert werden, mit denen der durch die Einlassöffnung 4 in das Modulgehäuse 2 eingeleitete Gasstrom in mehrere, zunächst parallel verlaufende Gasströme aufgeteilt wird. Die Gasströme können zunächst durch die Trennwände 9 getrennt voneinander geführt werden und können von den Trennwänden 9 in Richtung der innenliegenden Oberfläche 7 des Fensters 3 gelenkt werden, wo die Gasströme die innenliegende Oberfläche 7 des Fensters 3 im Inneren des Modulgehäuses 2 abschnittsweise überspülen. Im vorliegenden ersten Ausführungsbeispiel werden drei Abschnitte 10, 12, 14 der innenliegenden Oberfläche 7 des Fensters 3 quer zu einer Längsrichtung des Fensters 3 überspült. In dem Bereich des Fensters 3 sind keine Trennwände vorgesehen. Die Gasströme können über weitere Trennwände 9, die spiegelbildlich zu den Trennwänden 9 auf der Seite der Einlassöffnung 4 angeordnet sein können, zu der Ablassöffnung 5 geleitet werden. Dort vereinigen sich die Gasströme wieder und werden aus dem Modulgehäuse 2 abgeleitet.

Die Trennwände 9 auf der Seite der Ablassöffnung 5 dienen der Ausbildung einer möglichst laminaren Quer-Strömung über die innenliegende Oberfläche 7 des Fensters 3. Mit dem spiegelbildlichen Aufbau der mit den Trennwänden 9 gebildeten Leitungen 6 kann die Gasströmung auch umgekehrt durch das Modulgehäuse 2 strömen, das heißt, dass die Gasströmung auch durch die Ablassöffnung 5 in das Modulgehäuse 2 einströmen kann und durch die Einlassöffnung 4 aus dem Modulgehäuse 2 ausströmen kann. Unabhängig vom Anschluss wird mit dem Aufbau sichergestellt, dass die aufgeteilten Gasströmungen parallel zueinander die innenliegende Oberfläche 7 des Fensters 3 im Inneren des Modulgehäuses 2 abschnittsweise überspülen und so eine gleichmäßige Kühlung erreicht wird.

Der Strahler 1 kann über elektrische Anschlüsse 16 betrieben werden und über eine den elektrischen Anschlüssen 16 gegenüberliegende Befestigung 18 sowie über die elektrischen Anschlüsse 16 in dem Modulgehäuse 2 des Infrarot-Moduls gehalten werden.

Das Infrarot-Modul kann bevorzugt auch einen Reflektor 20 direkt über dem Strahler 1 aufweisen, um die Lichtausbeute des Infrarot-Moduls zu verbessern. Der Reflektor 20 kann eine Goldbeschichtung oder eine Quarz-Beschichtung aufweisen, um eine höhere Reflektivität für die Infrarot-Strahlung des Strahlers 1 zu erreichen. Der Reflektor 20 und der Strahler 1 können zusammen mit der innenliegenden Oberfläche 7 des Fensters 3 entlang der Abschnitte 10, 12, 14 mit den Gasströmungen überspült und dadurch äußerlich gekühlt werden. In dem Reflektor 20 können hierfür Öffnungen 22 angeordnet sein, die ein Durchströmen der Gasströmungen erlauben.

Der Strahler 1 kann ein Hüllrohr 24 und ein in dem Hüllrohr 24 eingeschlossenes Heizelement 26 aufweisen. Das Heizelement 26 kann aus einem für IR-Strahler passenden Material wie Kohlenstoff oder einer geeigneten Metalllegierung gefertigt sein, und über die elektrischen Anschlüsse 16 elektrisch kontaktiert werden. Die elektrischen Anschlüsse 16 sind mit einem elektrischen Anschluss 28 an der Außenseite des Modulgehäuses 2 verbunden. Die elektrische Durchführung durch das Modulgehäuse 2 kann abgedichtet und druckdicht sein.

An dem Modulgehäuse 2 können Rohre 30, 32 angeordnet sein, die mit der Einlassöffnung 4 und der Ablassöffnung 5 verbunden sind beziehungsweise diese begrenzen. Durch die Rohre 30, 32 kann die Gasströmung in das Modulgehäuse 2 eingeleitet und wieder aus dem Modulgehäuse 2 abgeführt werden.

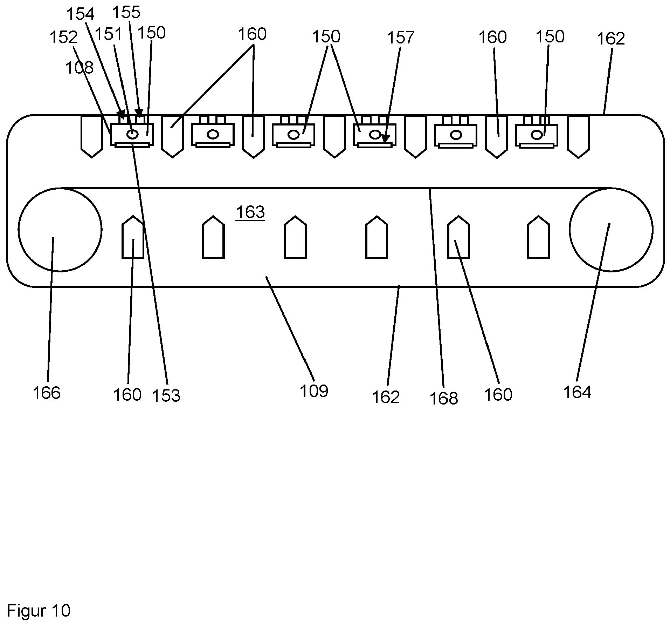

Das Infrarot-Modul kann das Fenster 3 in Form einer Quarzglasplatte aufweisen, die zur Transmission der IR-Strahlung in einen Prozessraum (in den Figuren 1 bis 4 nicht gezeigt, siehe aber Figur 10) geeignet und vorgesehen ist. Das Infrarot-Modul kann mit dem Modulgehäuse 2 nach außen gegenüber einem Teil der Umgebung, wie dem Prozessraum, abgedichtet sein und dabei vorzugsweise notwendige Schutzklassen erfüllen. Alternativ oder zusätzlich kann das Infrarot-Modul bis auf die Einlassöffnung 4 und die Ablassöffnung 5 vollständig gegen seine Umgebung abgedichtet werden und kann dann analog der Ausführung nach Figur 10 innerhalb des Prozessraums angeordnet werden. Zu- und Abluftleitungen sowie Energiezufuhr werden entsprechend mit Hilfe der Rohre 30, 32 und mit Hilfe von elektrischen Leitungen (nicht gezeigt), die an dem elektrischen Anschluss 28 an der Außenseite des Modulgehäuses 2 angeschlossen sind, aus dem Prozessraum herausgeführt.

Durch die Gasströmungsaufteilungseinrichtung 8 und die Leitungen 6 kann das Infrarot-Modul und das Fenster 3 abschnittsweise gasgekühlt werden (beispielsweise luftgekühlt werden). Die dadurch erreichte homogene Kühlung des Modulgehäuses 2 und des Fensters 3 erfolgt über ein Gasflussmanagement, das durch die Trennwände 9 und die Leitungen 6 im Inneren des Modulgehäuses 2 realisiert wird. Im Gegensatz zum Stand der Technik erfolgt die Kühlung nicht in Längsrichtung des Strahlers 1 und nicht in Längsrichtung des Fensters 3 beziehungsweise des Infrarot-Moduls sondern quer dazu. Dadurch wird das Infrarot-Modul auf seiner Gesamtlänge mit gleichmäßig kühlem Gas beziehungsweise gleichmäßig kühler Luft versorgt. Insbesondere das Fenster 3 wird mit gleichmäßig kühlem Gas entlang seiner kurzen Achse (also quer zur Längsachse des Fensters 3) überspült und gleichmäßig und effizient gekühlt. Die Verteilung des Gasstroms kann über die Trennwände 9 erfolgen, die dabei als Gasleitbleche für die Leitungen 6 fungieren. Diese unterteilen das Modulgehäuse 2 des Infrarot-Moduls in separate Lüftungsabschnitte entsprechend den Abschnitten 10, 12, 14. Es müssen nicht drei Abschnitte 10, 12, 14 gewählt werden. Die optimale Anzahl der Lüftungsabschnitte hängt von der Länge des Infrarot-Moduls und dem gewünschten Kühlmittelfluss beziehungsweise kühlenden Gasfluss ab (je nach erlaubter Maximaltemperatur). Eine Anpassung von Querschnitten und Luftmengen über die Länge des Strahlers 1 und des Fensters 3 ist somit möglich. Bevorzugt liegt im Infrarot-Modul ein Überdruck vor. Dieser verhindert im Falle einer Undichtigkeit das Eindringen entzündlicher Gase in das Modulgehäuse 2 zu dem Strahler 1, an denen sich das entzündliche Gas ansonsten entzünden könnte. Bevorzugt ist das Infrarot-Modul mit Drucksensoren (nicht gezeigt) ausgestattet um Leckage zu detektieren (z.B. einen Scheibenbruch des Fensters 3). Ebenso sind Bruchdetektoren (nicht gezeigt) für das Fenster 3 oder Drucksensoren (nicht gezeigt) zur Messung eines Druckabfalls denkbar. Mit solchen Sensoren kann auch der Volumenstrom des Gasstroms gesteuert werden oder eine Sicherheitsabschaltung erfolgen. Hierfür kann das Infrarot-Modul eine Steuerung aufweisen und mit einer zentralen Steuerung zum Zweck der Datenübertragung von den Sensoren verbunden sein oder werden. Auf diese Weise kann auch eine Einschränkung der verfügbaren Gasmenge und/oder Strömungsgeschwindigkeit (Lautstärke) erreicht werden oder eine andere "intelligente" Anpassung des Gasstroms oder der Gasströme erfolgen.

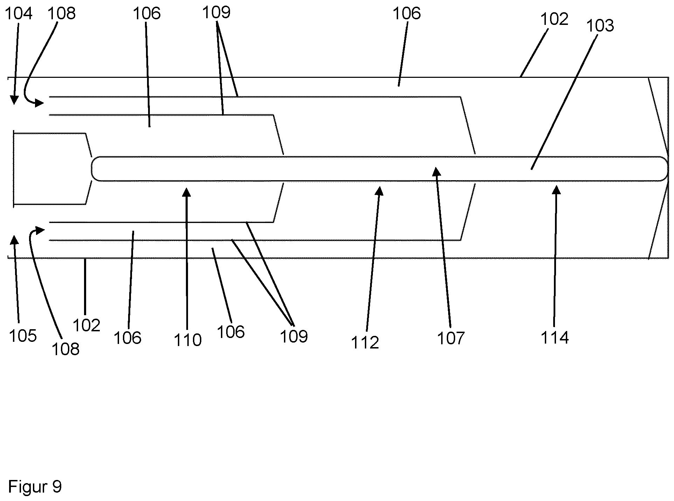

Anstelle von einem Infrarot-Strahler kann der Strahler 1 auch als UV-Strahler ausgeführt sein (siehe auch das dritte Ausführungsbeispiel nach Figur 9). Es handelt sich dann um ein UV-Modul anstatt um ein Infrarot-Modul. Hierzu muss das Fenster 3 dann für UV-Strahlung beziehungsweise für einen Wellenlängenbereich im UV-Spektrum durchlässig sein, was beispielsweise dadurch erreicht werden kann, dass ein Quarzglasfenster als Fenster 3 verwendet wird. Zudem sollte der Reflektor 20 zur Reflektion von UV-Licht geeignet sein und alle direkt mit dem UV-Licht des UV-Strahlers bestrahlten Teile des UV-Moduls gegenüber dem UV-Licht beständig sein. Anstelle des einzelnen Strahlers 1 können auch mehrere parallel zueinander angeordnete Strahler verwendet werden.

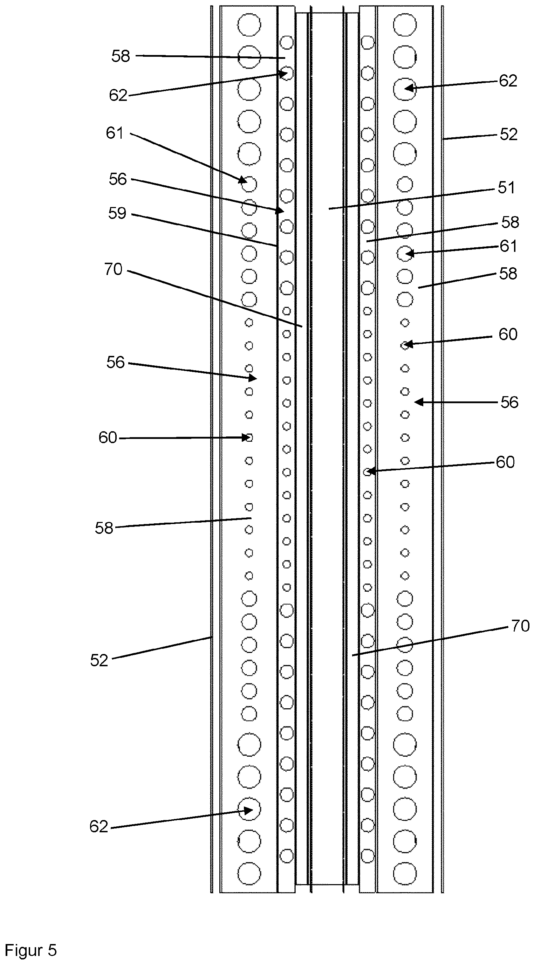

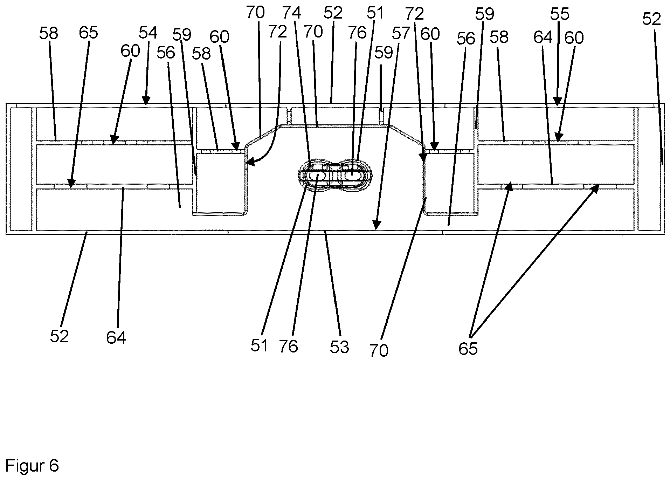

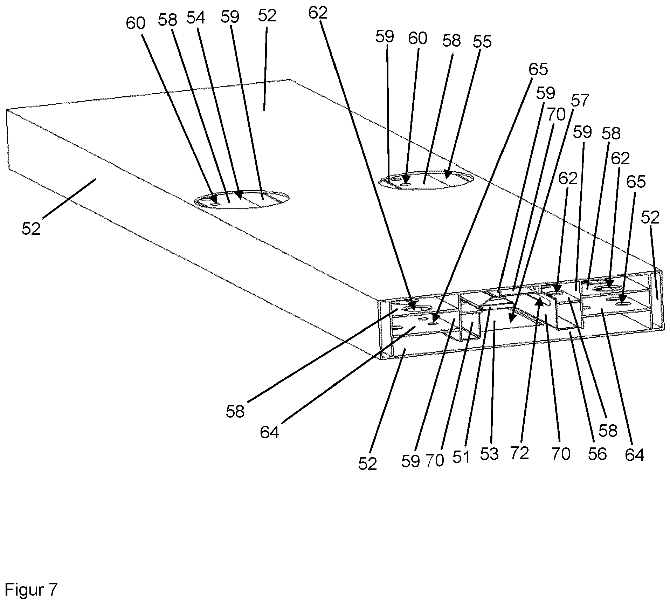

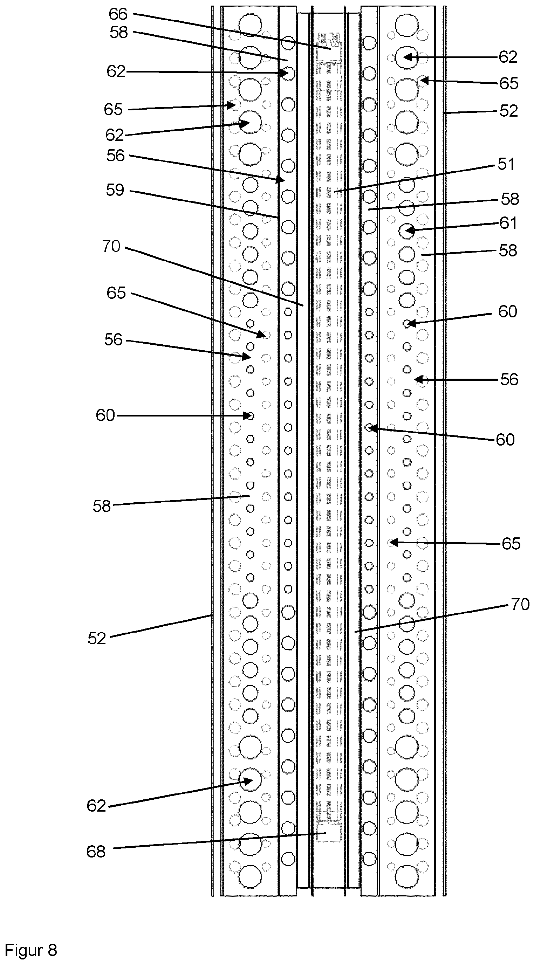

Alternativ können auch Lochplatten als Gasströmungsaufteilungseinrichtung verwendet werden, so wie das im zweiten Ausführungsbeispiel nach den Figuren 5 bis 8 gezeigt ist.

Die Figuren 5 bis 8 zeigen schematischen Ansichten eines zweiten erfindungsgemäßen Infrarot-Moduls. Das Infrarot-Modul kann einen Strahler 51 als Infrarot-Quelle aufweisen. Der Strahler 51 kann bevorzugt ein Kurzwellen- oder Karbon-Strahler sein. Der Strahler 51 ist in einem Modulgehäuse 52 mit einem Fenster 53 angeordnet. Das Modulgehäuse 52 kann aus Metallblechen und einem Quarzfenster als das Fenster 53 aufgebaut sein. Das Fenster 53 ist zumindest für einen Wellenlängenbereich im infraroten Wellenlängenspektrum transparent und ist vorzugsweise eine Quarzglasplatte. Das Fenster 53 kann eine rechteckige Form mit einer langen Längsachse und einer kurzen Seite in Querrichtung senkrecht dazu aufweisen. Das Fenster 53 erstreckt sich analog dem ersten Ausführungsbeispiel unterhalb des Strahlers 51 in einer Längsrichtung. An dem Modulgehäuse 52 ist eine Einlassöffnung 54 zum Einleiten eines Gasstroms in das Modulgehäuse 52 und eine Ablassöffnung 55 zum Ableiten eines Gasstroms aus dem Modulgehäuse 52 angeordnet. Im Inneren des Modulgehäuses 52 sind Leitungen 56 zum Leiten des Gasstroms von der Einlassöffnung 54 zur Ablassöffnung 55 vorgesehen, wobei der Gasstrom über eine innenliegende Oberfläche 57 des Fensters 53 geleitet wird.

Zum Leiten des Gasstroms weist das Infrarot-Modul im Inneren des Modulgehäuses 52 erfindungsgemäß eine Gasströmungsaufteilungseinrichtung 58 in Form zumindest einer Lochplatte auf. Diese Gasströmungsaufteilungseinrichtung 58 kann durch eine Mehrzahl von Lochplatten 58, 64 und Trennwänden 59 realisiert werden, mit denen der durch die Einlassöffnung 54 in das Modulgehäuse 52 eingeleitete Gasstrom in mehrere, zunächst parallel verlaufende Gasströme aufgeteilt wird. Die Gasströme können direkt nach den Lochplatten 58, 64 wieder zusammenströmen und können von den Trennwänden 59 und seitlichen Öffnungen (in den Figuren 5 bis 8 nicht zu sehen) darin in Richtung der innenliegenden Oberfläche 57 des Fensters 53 gelenkt werden, wo die Gasströme die innenliegende Oberfläche 57 des Fensters 53 im Inneren des Modulgehäuses 52 abschnittsweise nebeneinander überspülen. Im vorliegenden Ausführungsbeispiel werden viele Abschnitte der innenliegenden Oberfläche 57 des Fensters 53 quer zu der Längsrichtung des Fensters 53 überspült. In dem Bereich des Fensters 53 sind keine Trennwände vorgesehen. Die Gasströme können über weitere Trennwände 59 und Lochplatten 58, 64, die spiegelbildlich zu den Trennwänden 59 und der Gasströmungsaufteilungseinrichtung 58, 64 beziehungsweise den Lochplatten 58, 64 auf der Seite der Einlassöffnung 54 angeordnet sein können, zu der Ablassöffnung 55 geleitet werden. Dort werden die Gasströme wieder in gleichmäßiger Strömung aus dem Modulgehäuse 52 abgeleitet.

Die Anordnung der Lochplatten 58, 64 und Trennwände 59 auf der Seite der Ablassöffnung dient der Ausbildung einer möglichst laminaren Quer-Strömung über die innenliegende Oberfläche 57 des Fensters 53. Mit dem spiegelbildlichen Aufbau der mit den Lochplatten 58, 64 und Trennwänden 59 gebildeten Leitungen 56 kann die Gasströmung auch umgekehrt durch das Modulgehäuse 52 strömen, das heißt, dass die Gasströmung auch durch die Ablassöffnung 55 in das Modulgehäuse 52 einströmen kann und durch die Einlassöffnung 54 aus dem Modulgehäuse 52 ausströmen kann. Unabhängig vom Anschluss wird mit dem Aufbau sichergestellt, dass die aufgeteilten Gasströmungen parallel zueinander die innenliegende Oberfläche 57 des Fensters 53 im Inneren des Modulgehäuses 52 abschnittsweise überspülen und so eine gleichmäßige Kühlung erreicht wird.

Der Strahler 51 kann über elektrische Anschlüsse 66 betrieben werden und über eine den elektrischen Anschlüssen 66 gegenüberliegende Befestigung 68 sowie über die elektrischen Anschlüsse 66 in dem Modulgehäuse 52 des Infrarot-Moduls gehalten werden.

Das Infrarot-Modul kann bevorzugt auch einen Reflektor 70 direkt über dem Strahler 51 aufweisen, um die Lichtausbeute des Infrarot-Moduls zu verbessern. Der Reflektor 70 kann eine Goldbeschichtung oder eine Quarz-Beschichtung aufweisen, um eine höhere Reflektivität für die Infrarot-Strahlung des Strahlers 51 zu erreichen. Der Reflektor 70 und der Strahler 51 können zusammen mit der innenliegenden Oberfläche 57 des Fensters 53 mit den durch die Gasströmungsaufteilungseinrichtung 58, 64 beziehungsweise die Lochplatten 58, 64 und Trennwänden 59 erzeugten Gasströmungen überspült und dadurch äußerlich gekühlt werden. In dem Reflektor 70 können hierfür Öffnungen 72 angeordnet sein, die ein Durchströmen der Gasströmungen erlauben.

Der Strahler 51 kann ein Hüllrohr 74 und ein in dem Hüllrohr 74 eingeschlossenes Heizelement 76 aufweisen. Das Heizelement 76 kann aus einem für IR-Strahler passenden Material wie Kohlenstoff oder einer geeigneten Metalllegierung oder reine Metalle wie Wolfram gefertigt sein, und über die elektrischen Anschlüsse 66 elektrisch beheizt werden. Die elektrischen Anschlüsse 66 sind mit einem elektrischen Anschluss (nicht gezeigt) an der Außenseite des Modulgehäuses 52 verbunden sein, können aber auch entlang von Rohren zum Einspeisen und Ableiten des Gasstroms elektrisch kontaktiert werden. Die elektrische Durchführung durch das Modulgehäuse 52 kann abgedichtet und druckdicht sein.

An dem Modulgehäuse 52 können Rohre (nicht gezeigt) analog zum ersten Ausführungsbeispiel angeordnet sein, die mit der Einlassöffnung 54 und der Ablassöffnung 55 verbunden sind beziehungsweise diese begrenzen. Durch die Rohre kann die Gasströmung in das Modulgehäuse 52 eingeleitet und wieder aus dem Modulgehäuse 52 abgeführt werden. Das Infrarot-Modul kann das Fenster 53 in Form einer Quarzglasplatte aufweisen, die zur Transmission der IR-Strahlung in einen Prozessraum (in den Figuren 5 bis 8 nicht gezeigt, siehe aber Figur 10) geeignet und vorgesehen ist. Das Infrarot-Modul kann mit dem Modulgehäuse 52 nach außen gegenüber einem Teil der Umgebung, wie dem Prozessraum, abgedichtet sein und dabei vorzugsweise notwendige Schutzklassen erfüllen. Alternativ oder zusätzlich kann das Infrarot-Modul bis auf die Einlassöffnung 54 und die Ablassöffnung 55 vollständig gegen seine Umgebung abgedichtet werden und kann dann analog der Ausführung nach Figur 10 innerhalb des Prozessraums angeordnet werden. Zu- und Abluftleitungen sowie Energiezufuhr werden entsprechend mit Hilfe der Rohre und mit Hilfe von elektrischen Leitungen (nicht gezeigt) aus dem Prozessraum herausgeführt.

Durch die Gasströmungsaufteilungseinrichtung 58, 64 beziehungsweise durch die Lochplatten 58, 64 und die Leitungen 56 kann das Infrarot-Modul und das Fenster 53 abschnittsweise gasgekühlt werden (beispielsweise luftgekühlt werden). Die dadurch erreichte homogene Kühlung des Modulgehäuses 52 und des Fensters 53 erfolgt über ein Gasflussmanagement, das durch die Lochplatten 58, 64, die Trennwände 59 und die Leitungen 56 im Inneren des Modulgehäuses 52 realisiert wird. Im Gegensatz zum Stand der Technik erfolgt die Kühlung nicht in Längsrichtung des Strahlers 51 und nicht in Längsrichtung des Fensters 53 beziehungsweise des Infrarot-Moduls sondern quer dazu. Dadurch wird das Infrarot-Modul auf seiner Gesamtlänge mit gleichmäßig kühlem Gas beziehungsweise gleichmäßig kühler Luft versorgt. Insbesondere das Fenster 53 wird mit gleichmäßig kühlem Gas entlang seiner kurzen Achse (also quer zur Längsachse des Fensters 53) überspült und gleichmäßig und effizient gekühlt.

Die Verteilung des Gasstroms kann über die Gasströmungsaufteilungseinrichtung 58, 64 erfolgen. Diese erzwingen eine senkrecht zur Längsrichtung des Fensters verlaufende gleichmäßig starke und homogene Gasströmung entlang den Abschnitten des Fensters 53 des Infrarot-Moduls.

Die in Strömungsrichtung des Gasstroms zuvorderst angeordneten Lochplatten 58 können kleine Löcher 60, mittlere Löcher und große Löcher 62 oder kleine Löcher 60 und große Löcher 62 aufweisen. Die Größe der Löcher 60, 61, 62 bezieht sich dabei auf den freien Querschnitt der Löcher 60, 61, 62, der zum im wesentlichen ungehinderten Durchströmen von Gas beiträgt. Die Größe der Löcher 60, 61, 62 nimmt vorzugsweise mit zunehmendem Abstand von der Einlassöffnung 54 beziehungsweise von der Ablassöffnung 55 zu. Dadurch kann erreicht werden, dass die weiter von der Einlassöffnung 54 und der Ablassöffnung 55 entfernten Gasströmungen keinen geringeren Volumenstrom aufweisen als die dichter daran strömenden Gasströmungen. Auch in den in Strömungsrichtung des Gasstroms dahinter angeordneten Lochplatten 64 können Löcher 65 angeordnet sein, die einer weiteren Vergleichmäßigung der Gasströmungen in dem Modulgehäuse 52 dienen.

Die optimale Anzahl der Löcher 60, 61, 62, 65 und der Lochplatten 58, 64 und die optimale Anordnung der Trennwände 59 hängt von der Länge des Infrarot-Moduls und dem gewünschten Kühlmittelfluss beziehungsweise kühlenden Gasfluss ab (je nach erlaubter Maximaltemperatur). Eine Anpassung von Querschnitten und Luftmengen über die Länge des Strahlers 51 und des Fensters 53 ist somit möglich. Bevorzugt liegt im Infrarot-Modul ein Überdruck vor. Dieser verhindert im Falle einer Undichtigkeit das Eindringen entzündlicher Gase in das Modulgehäuse 52 zu dem Strahler 51, an dem sich das entzündliche Gas ansonsten entzünden könnte.

Bevorzugt ist das Infrarot-Modul mit Drucksensoren (nicht gezeigt) ausgestattet um Leckage zu detektieren (z.B. einen Scheibenbruch des Fensters 53). Ebenso sind Bruchdetektoren (nicht gezeigt) für das Fenster 53 oder Drucksensoren (nicht gezeigt) zur Messung eines Druckabfalls denkbar. Mit solchen Sensoren kann auch der Volumenstrom des Gasstroms gesteuert werden oder eine Sicherheitsabschaltung erfolgen. Hierfür kann das Infrarot-Modul eine Steuerung aufweisen und mit einer zentralen Steuerung zum Zweck der Datenübertragung von den Sensoren verbunden sein oder werden. Auf diese Weise kann auch eine Einschränkung der verfügbaren Gasmenge und/oder Strömungsgeschwindigkeit (Lautstärke) erreicht werden oder eine andere "intelligente" Anpassung des Gasstroms oder der Gasströme erfolgen.

Anstelle von einem Infrarot-Strahler kann der Strahler 51 auch als zumindest ein UV-Strahler ausgeführt sein. Es handelt sich dann um ein UV-Modul anstatt um ein Infrarot-Modul. Hierzu muss das Fenster 53 dann für UV-Strahlung beziehungsweise für einen Wellenlängenbereich im UV-Spektrum durchlässig sein, was beispielsweise dadurch erreicht werden kann, dass ein Quarzglasfenster als Fenster 53 verwendet wird. Zudem sollte der Reflektor 70 zur Reflektion von UV-Licht geeignet sein und alle direkt mit dem UV-Licht der UV-Strahler bestrahlten Teile des UV-Moduls gegenüber dem UV-Licht beständig sein. Anstelle des einzelnen Strahlers 1 können auch mehrere parallel zueinander angeordnete Strahler verwendet werden.

Figur 9 zeigt einen schematischen Aufbau eines dritten erfindungsgemäßen Infrarot-Moduls oder UV-Moduls. Das Infrarot-Modul oder UV-Modul kann zumindest einen Infrarot-Strahler als Infrarot-Quelle (beispielsweise Keramikstrahler, Karbonstrahler oder andere IR-Strahler) oder zumindest einen UV-Strahler als UV-Quelle (beispielsweise ein UV-LED-Array) aufweisen. Der zumindest eine Infrarot-Strahler oder zumindest eine UV-Strahler sind in Figur 9 nicht zu sehen aber analog den vorherigen beiden Ausführungen über einem länglichen Fenster 103 angeordnet. Sie sind in einem Modulgehäuse 102 mit dem Fenster 103 angeordnet. Das Fenster 103 ist zumindest für einen Wellenlängenbereich im infraroten Wellenlängenspektrum und/oder im ultravioletten Wellenlängenspektrum transparent und ist vorzugsweise eine Quarzglasplatte. Das Fenster 103 kann eine rechteckige Form mit abgerundeten Ecken und mit einer langen Längsachse und einer kurzen Seite in Querrichtung senkrecht dazu aufweisen. An dem Modulgehäuse 102 ist eine Einlassöffnung 104 zum Einleiten eines Gasstroms in das Modulgehäuse 102 und eine Ablassöffnung 105 zum Ableiten eines Gasstroms aus dem Modulgehäuse 102 angeordnet. Im Inneren des Modulgehäuses 102 sind Leitungen 106 zum Leiten des Gasstroms von der Einlassöffnung 104 zur Ablassöffnung 105 vorgesehen, wobei der Gasstrom über eine innenliegende Oberfläche 107 des Fensters 103 geleitet wird.

Zum Leiten des Gasstroms weist das Infrarot-Modul oder UV-Modul im Inneren des Modulgehäuses 102 erfindungsgemäß eine Gasströmungsaufteilungseinrichtung 108 auf. Diese Gasströmungsaufteilungseinrichtung 108 kann durch eine Mehrzahl von Trennwänden 109 realisiert werden, mit denen der durch die Einlassöffnung 104 in das Modulgehäuse 102 eingeleitete Gasstrom in mehrere, zunächst parallel verlaufende Gasströme aufgeteilt wird. Die Gasströme können zunächst durch die Trennwände 109 getrennt voneinander geführt werden und können von den Trennwänden 109 in Richtung der innenliegenden Oberfläche 107 des Fensters 103 gelenkt werden, wo die Gasströme die innenliegende Oberfläche 107 des Fensters 103 im Inneren des Modulgehäuses 102 abschnittsweise überspülen. Im vorliegenden dritten Ausführungsbeispiel werden drei Abschnitte 110, 112, 114 der innenliegenden Oberfläche 107 des Fensters 103 quer zu einer Längsrichtung des Fensters 103 überspült. In dem Bereich des Fensters 103 sind keine Trennwände vorgesehen. Die Gasströme können über weitere Trennwände 109, die spiegelbildlich zu den Trennwänden 109 auf der Seite der Einlassöffnung 104 angeordnet sein können, zu der Ablassöffnung 105 geleitet werden. Dort vereinigen sich die Gasströme wieder und werden aus dem Modulgehäuse 102 abgeleitet.

Die Trennwände 109 auf der Seite der Ablassöffnung 105 dienen der Ausbildung einer möglichst laminaren Quer-Strömung über die innenliegende Oberfläche 107 des Fensters 103. Mit dem spiegelbildlichen Aufbau der mit den Trennwänden 109 gebildeten Leitungen 106 kann die Gasströmung auch umgekehrt durch das Modulgehäuse 102 strömen, das heißt, dass die Gasströmung auch durch die Ablassöffnung 105 in das Modulgehäuse 102 einströmen kann und durch die Einlassöffnung 104 aus dem Modulgehäuse 102 ausströmen kann. Unabhängig vom Anschluss wird mit dem Aufbau sichergestellt, dass die aufgeteilten Gasströmungen parallel zueinander die innenliegende Oberfläche 107 des Fensters 103 im Inneren des Modulgehäuses 102 abschnittsweise überspülen und so eine gleichmäßige Kühlung erreicht wird.

Das Infrarot-Modul oder UV-Modul kann das Fenster 103 in Form einer Quarzglasplatte aufweisen, die zur Transmission der IR-Strahlung oder UV-Strahlung in einen Prozessraum (in Figur 9 nicht gezeigt, siehe aber Figur 10) geeignet und vorgesehen ist. Das Infrarot-Modul oder UV-Modul kann mit dem Modulgehäuse 102 nach außen gegenüber einem Teil der Umgebung, wie dem Prozessraum, abgedichtet sein und dabei vorzugsweise notwendige Schutzklassen erfüllen. Alternativ oder zusätzlich kann das Infrarot-Modul oder UV-Modul bis auf die Einlassöffnung 104 und die Ablassöffnung 105 vollständig gegen seine Umgebung abgedichtet werden und kann dann analog der Ausführung nach Figur 10 innerhalb des Prozessraums angeordnet werden.

Durch die Gasströmungsaufteilungseinrichtung 108 und die Leitungen 106 kann das Infrarot-Modul oder UV-Modul und das Fenster 103 abschnittsweise gasgekühlt werden (beispielsweise luftgekühlt werden). Die dadurch erreichte homogene Kühlung des Modulgehäuses 102 und des Fensters 103 erfolgt über ein Gasflussmanagement, das durch die Trennwände 109 und die Leitungen 106 im Inneren des Modulgehäuses 102 realisiert wird. Im Gegensatz zum Stand der Technik erfolgt die Kühlung nicht in Längsrichtung des Infrarot-Strahlers oder UV-Strahlers und nicht in Längsrichtung des Fensters 103 beziehungsweise des Infrarot-Moduls oder UV-Moduls sondern quer dazu. Dadurch wird das Infrarot-Modul oder UV-Modul auf seiner Gesamtlänge mit gleichmäßig kühlem Gas beziehungsweise gleichmäßig kühler Luft versorgt. Insbesondere das Fenster 103 wird mit gleichmäßig kühlem Gas entlang seiner kurzen Achse (also quer zur Längsachse des Fensters 103) überspült und gleichmäßig und effizient gekühlt. Die Verteilung des Gasstroms kann über die Trennwände 109 erfolgen, die dabei als Gasleitbleche für die Leitungen 106 fungieren. Diese unterteilen das Modulgehäuse 102 des Infrarot-Moduls in separate Lüftungsabschnitte entsprechend den Abschnitten 110, 112, 114. Es müssen nicht drei Abschnitte 110, 112, 114 gewählt werden. Die optimale Anzahl der Lüftungsabschnitte hängt von der Länge des Infrarot-Moduls oder UV-Moduls und dem gewünschten Kühlmittelfluss beziehungsweise kühlenden Gasfluss ab (je nach erlaubter Maximaltemperatur). Eine Anpassung von Querschnitten und Luftmengen über die Länge des zumindest einen Infrarot-Strahlers oder des zumindest einen UV-Strahlers und des Fensters 103 ist somit möglich. Bevorzugt liegt im IR-Modul oder UV-Modul ein Überdruck vor. Dieser verhindert im Falle einer Undichtigkeit das Eindringen entzündlicher Gase in das Modulgehäuse 102 zu dem zumindest einen Infrarot-Strahler oder dem zumindest einen UV-Strahler, an dem sich das entzündliche Gas ansonsten entzünden könnte.

Bevorzugt ist das Infrarot-Modul oder UV-Modul mit Drucksensoren (nicht gezeigt) ausgestattet um Leckage zu detektieren (z.B. einen Scheibenbruch des Fensters 103). Ebenso sind Bruchdetektoren (nicht gezeigt) für das Fenster 103 oder Drucksensoren (nicht gezeigt) zur Messung eines Druckabfalls denkbar. Mit solchen Sensoren kann auch der Volumenstrom des Gasstroms gesteuert werden oder eine Sicherheitsabschaltung erfolgen. Hierfür kann das Infrarot-Modul oder UV-Modul eine Steuerung aufweisen und mit einer zentralen Steuerung zum Zweck der Datenübertragung von den Sensoren verbunden sein oder werden. Auf diese Weise kann auch eine Einschränkung der verfügbaren Gasmenge und/oder Strömungsgeschwindigkeit (Lautstärke) erreicht werden oder eine andere "intelligente" Anpassung des Gasstroms oder der Gasströme erfolgen.

Figur 10 zeigt eine schematische vertikale Querschnittansicht einer erfindungsgemäßen Bearbeitungsanlage zur Veränderung eines Stoffs mittels Infrarotstrahlung oder UV-Strahlung enthaltend sechs erfindungsgemäße Infrarot-Module oder UV-Module 150. Es können aber auch mehr oder weniger Infrarot-Module oder UV-Module 150 in der Bearbeitungsanlage vorhanden sein. Die Infrarot-Module oder UV-Module 150 sind bevorzugt nach einer der ersten drei Ausführungsbeispiele nach den Figuren 1 bis 4, 5 bis 8 oder 9 aufgebaut. Jedes Infrarot-Module oder UV-Module 150 weist zumindest einen Strahler 151, ein Modulgehäuse 152 mit einer Gasströmungsaufteilungseinrichtung (nicht zu sehen) und mit Leitungen zum Leiten von Gasströmen (nicht zu sehen) über eine innenliegende Oberfläche 157 eines Fensters 153, eine Einlassöffnung 154 und eine Ablassöffnung 155 auf. Der Aufbau und die Funktionsweise der Infrarot-Module oder UV-Module 150 entspricht den vorherigen Ausführungsbeispielen.

Die Infrarot-Module oder UV-Module 150 sind zwischen Gebläsen 160 in einem Anlagengehäuse 162 angeordnet. Das Anlagengehäuse umschließt einen Prozessraum 163. Die Infrarot-Module oder UV-Module 150 und die Gebläse 160 sind innerhalb des Anlagengehäuses 162 im Prozessraum 163 angeordnet. Das innere der Infrarot-Module oder UV-Module 150 ist mit den Modulgehäuses 152 gegen den Prozessraum 163 abgedichtet. Die Bearbeitungsanlage kann ferner auch noch zumindest eine Vorrichtung zum Auftragen einer zu trocknenden oder auszuhärtenden Beschichtung (das "Slurry") aufweisen. Die Beschichtung wird in der Bearbeitungsanlage aufgetragen und getrocknet, so dass das Endprodukt auf der aufwickelnden Rolle unempfindlich(er) gegen chemische und mechanische Einflüsse ist, beziehungsweise das aufgerollte Produkt nicht an sich selbst klebt oder haftet.

Im Prozessraum 163 sind zwei Halterungen 164, 166 angeordnet, die beispielsweise als Rollen ausgeführt sein können. Die Halterungen 164, 166 können auch außerhalb des Prozessraums 163 angeordnet sein. Die Halterungen 164, 166 halten einen Draht 168 oder ein Band oder eine Folie als den mit den Infrarot-Modulen oder UV-Modulen 150 zu bestrahlenden Stoff in dem Prozessraum 163. Es kann auch ein Drahtgeflecht oder ein Band als Träger vorgesehen sein, auf dem der zu bestrahlende Stoff angeordnet oder befestigt ist. Mit Hilfe der Gebläse 160 wird der Draht 168, das Band, die Folie oder der Träger schwebend gelagert. Durch das Schweben kann auf weitere Rollen zum Leiten des Drahts 168, des Bands, der Folie oder des Trägers verzichtet werden und das zu beschichtende Material kann nicht durch die Berührung kontaminiert beziehungsweise die Beschichtung im Trocknungsprozess nicht beschädigt werden. Auch die Gebläse 160 wirken auf den Draht 168 oder das Band ein und halten diesen beziehungsweise dieses in der Schwebe. Bevorzugt wird der Draht 168 oder das Band mit den Rollen im Prozessraum 163 gefördert und mit Hilfe der Gebläse 160 und der Infrarot-Module oder UV-Module 150 getrocknet und/oder gehärtet. Die Bearbeitungsanlage kann folglich vorzugsweise eine Trocknungsanlage oder eine Härtungsanlage sein. Die Gefahr einer Entzündung von bei der Anwendung der Bearbeitungsanlage entstehenden Gase im Prozessraum 163 ist durch die gleichmäßige Kühlung mit den Infrarot-Modulen oder UV-Modulen 150 deutlich reduziert.

Die in der voranstehenden Beschreibung, sowie den Ansprüchen, Figuren und Ausführungsbeispielen offenbarten Merkmale der Erfindung können sowohl einzeln, als auch in jeder beliebigen Kombination für die Verwirklichung der Erfindung in ihren verschiedenen Ausführungsformen wesentlich sein.

### Bezugszeichenliste

- 1,51, 151: Strahler
- 2, 52, 102, 152: Modulgehäuse
- 3, 53, 103, 153: Fenster
- 4, 54, 104, 154: Einlassöffnung
- 5, 55, 105, 155: Ablassöffnung
- 6, 56, 106: Leitung
- 7, 57, 107, 157: innenliegende Oberfläche des Fensters
- 8, 108: Gasströmungsaufteilungseinrichtung
- 9, 59, 109: Trennwand
- 10, 110: erster Abschnitt
- 12, 112: zweiter Abschnitt
- 14, 113: dritter Abschnitt
- 16,66: elektrische Anschlüsse
- 18, 68: Befestigung
- 20, 70: Reflektor
- 22, 72: Öffnung
- 24, 74: Hüllrohr
- 26, 76: Heizelement
- 28: elektrischer Anschluss
- 30: Rohr
- 32: Rohr
- 58: Gasströmungsaufteilungseinrichtung / Lochplatte
- 60: kleines Loch
- 61: mittleres Loch
- 62: großes Loch
- 64: Gasströmungsaufteilungseinrichtung / Lochplatte
- 65: Loch
- 150: IR-Modul oder UV-Modul
- 160: Gebläse
- 162: Anlagengehäuse
- 163: Prozessraum
- 164: Halterung
- 166: Halterung
- 168: Draht

## Patentansprüche

1. Infrarot-Modul (150) aufweisend zumindest einen Strahler (1, 51, 151) in Form zumindest eines Infrarotstrahlers oder
UV-Modul (150) aufweisend zumindest einen Strahler (1, 51, 151) in Form zumindest eines UV-Strahlers,
das Infrarot-Modul oder UV-Modul (150) aufweisend ein Modulgehäuse (2, 52, 102, 152) mit einem Fenster (3, 53, 103, 153), wobei das Modulgehäuse (2, 52, 102, 152) den zumindest einen Strahler (1, 51, 151) umhüllt, wobei das Fenster (3, 53, 103, 153) passend zum Strahler (1, 51, 151) aus einem für Infrarotstrahlung eines Wellenlängenbereichs im infraroten Spektrum des Lichts durchlässigen Material oder aus einem für UV-Strahlung eines Wellenlängenbereichs im ultravioletten Spektrum des Lichts durchlässigen Material besteht und der zumindest eine Strahler (1, 51, 151) derart in dem Modulgehäuse (2, 52, 102, 152) angeordnet ist, dass eine von dem zumindest einen Infrarotstrahler abgestrahlte Infrarotstrahlung durch das Fenster (3, 53, 103, 153) aus dem Infrarot-Modul (150) herausstrahlt oder eine von dem zumindest einen UV-Strahler abgestrahlte UV-Strahlung durch das Fenster (3, 53, 103, 153) aus dem UV-Modul (150) herausstrahlt, wobei das Modulgehäuse (2, 52, 102, 152) eine Einlassöffnung (4, 54, 104, 154) zum Zuführen eines Gasstroms in das Modulgehäuse (2, 52, 102, 152) hinein und zumindest eine Ablassöffnung (5, 55, 105, 155) zum Ableiten des Gasstroms aus dem Modulgehäuse (2, 52, 102, 152) heraus aufweist, wobei das Modulgehäuse (2, 52, 102, 152) zumindest eine Leitung (6, 56, 106) zum Leiten des Gasstroms aus der Einlassöffnung (4, 54, 104, 154) über eine innenliegende Oberfläche (7, 57, 107, 157) des Fensters (3, 53, 103, 153) zu der zumindest einen Ablassöffnung (5, 55, 105, 155) aufweist, wobei die innenliegende Oberfläche (7, 57, 107, 157) des Fensters (3, 53, 103, 153) in das Modulgehäuse (2, 52, 102, 152) hinein ausgerichtet ist, wobei das Modulgehäuse (2, 52, 102, 152) eine Gasströmungsaufteilungseinrichtung (8, 58, 64, 108) aufweist, wobei die Gasströmungsaufteilungseinrichtung (8, 58, 64, 108) den Gasstrom aus der Einlassöffnung (4, 54, 104, 154) innerhalb des Modulgehäuses (2, 52, 102, 152) in mehrere Gasströmungen aufteilt und wobei das Modulgehäuse (2, 52, 102, 152) die mehreren Gasströmungen oder einen ersten Anteil der mehreren Gasströmungen derart leitet, dass die mehreren Gasströmungen oder der erste Anteil der mehreren Gasströmungen die innenliegende Oberfläche (7, 57, 107, 157) des Fensters (3, 53, 103, 153) abschnittsweise überspülen.

2. Infrarot-Modul oder UV-Modul (150) nach Anspruch 1, **dadurch gekennzeichnet, dass**
die mehreren Gasströmungen oder der erste Anteil der mehreren Gasströmungen die innenliegende Oberfläche (7, 57, 107, 157) des Fensters (3, 53, 103, 153) in zumindest 70% der gesamten innenliegenden Oberfläche des Fensters (3, 53, 103, 153) überspülen oder die innenliegende Oberfläche (7, 57, 107, 157) des Fensters (3, 53, 103, 153) vollständig überspülen,
bevorzugt die mehreren Gasströmungen oder der erste Anteil der mehreren Gasströmungen die innenliegende Oberfläche (7, 57, 107, 157) des Fensters (3, 53, 103, 153) in zumindest 90% der gesamten innenliegenden Oberfläche des Fensters (3, 53, 103, 153) überspülen oder die innenliegende Oberfläche (7, 57, 107, 157) des Fensters (3, 53, 103, 153) vollständig überspülen.

3. Infrarot-Modul oder UV-Modul (150) nach Anspruch 1 oder 2, **dadurch gekennzeichnet, dass**
das Modulgehäuse (2, 52, 102, 152) die mehreren Gasströmungen oder einen zweiten Anteil der mehreren Gasströmungen derart über den zumindest einen Strahler (1, 51, 151) führt, dass die mehreren Gasströmungen oder der zweite Anteil der mehreren Gasströmungen eine äußere Oberfläche des zumindest einen Strahlers (1, 51, 151) abschnittsweise überspülen, und/oder
das Fenster (3, 53, 103, 153) einen Teil der Außenwand des Modulgehäuses (2, 52, 102, 152) begrenzt, bevorzugt das Fenster (3, 53, 103, 153) einen Teil der Außenwand des Modulgehäuses (2, 52, 102, 152) auf einer Seite des Modulgehäuses (2, 52, 102, 152) begrenzt, besonders bevorzugt das Fenster (3, 53, 103, 153) einen Teil der Außenwand des Modulgehäuses (2, 52, 102, 152) auf einer Unterseite der Modulgehäuses (2, 52, 102, 152) begrenzt.

4. Infrarot-Modul oder UV-Modul (150) nach einem der vorangehenden Ansprüche, **dadurch gekennzeichnet, dass**
das Fenster (3, 53, 103, 153) eine langgestreckte Geometrie mit zwei einander gegenüberliegend angeordneten langen Seiten hat, wobei die mehreren Gasströmungen die innenliegende Oberfläche (7, 57, 107, 157) des Fensters (3, 53, 103, 153) von einer der langen Seite des Fensters (3, 53, 103, 153) bis zu der gegenüberliegend angeordneten langen Seite des Fensters (3, 53, 103, 153) abschnittsweise überspülen, wobei das Fenster (3, 53, 103, 153) vorzugsweise eine rechteckige Geometrie hat, und/oder
die mehreren Gasströmungen die innenliegende Oberfläche (7, 57, 107, 157) des Fensters (3, 53, 103, 153) quer zu einer Längsrichtung des Fensters (3, 53, 103, 153) überspülen, wobei bevorzugt die mehreren Gasströmungen die innenliegende Oberfläche (7, 57, 107, 157) des Fensters (3, 53, 103, 153) in einem Winkel von 20° bis 90° zu der Längsrichtung des Fensters (3, 53, 103, 153) überspülen, besonders bevorzugt die mehreren Gasströmungen die innenliegende Oberfläche (7, 57, 107, 157) des Fensters (3, 53, 103, 153) in einem Winkel von 45° bis 90° zu der Längsrichtung des Fensters (3, 53, 103, 153) überspülen, ganz besonders bevorzugt die mehreren Gasströmungen die innenliegende Oberfläche (7, 57, 107, 157) des Fensters (3, 53, 103, 153) in einem Winkel von 80° bis 90° zu der Längsrichtung des Fensters (3, 53, 103, 153) überspülen.

5. Infrarot-Modul oder UV-Modul (150) nach einem der vorangehenden Ansprüche, **dadurch gekennzeichnet, dass**
innerhalb des Modulgehäuses (2, 52, 102, 152) zumindest ein Reflektor (20, 70) angeordnet ist, wobei mit dem zumindest einen Reflektor (20, 70) ein Teil der von dem zumindest einen Strahler (1, 51, 151) abgestrahlten Infrarotstrahlung oder der UV-Strahlung durch das Fenster (3, 53, 103, 153) aus dem Infrarot-Modul oder UV-Modul (150) heraus-reflektierbar ist,
wobei bevorzugt der zumindest eine Reflektor (20, 70) eine metallische oder metallisierte Reflektor-Oberfläche zum Reflektieren des Teils der von dem zumindest einen Strahler (1, 51, 151) abgestrahlten Infrarotstrahlung oder der UV-Strahlung durch das Fenster (3, 53, 103, 153) aufweist, besonders bevorzugt eine mit SiO2, mit Gold beschichtete und/oder metallisierte Reflektor-Oberfläche aufweist, und/oder
wobei bevorzugt in dem zumindest einen Reflektor (20, 70) Öffnungen (22, 72) zum Durchleiten der mehreren Gasströmungen oder zum Durchleiten von einem dritten Anteil der mehreren Gasströmungen angeordnet sind, so dass die mehreren Gasströmungen oder der dritte Anteil der Gasströmungen den zumindest einen Reflektor (20, 70) abschnittsweise überspülen, insbesondere eine Reflektor-Oberfläche des zumindest einen Reflektors (20, 70) überspülen.

6. Infrarot-Modul oder UV-Modul (150) nach einem der vorangehenden Ansprüche, **dadurch gekennzeichnet, dass**
die Gasströmungsaufteilungseinrichtung (8, 58, 64, 108) in der zumindest einen Leitung (6, 56, 106) zum Leiten des Gasstroms aus der Einlassöffnung (4, 54, 104, 154) zumindest eine Lochplatte (58, 64) mit mehreren Löchern (60, 61, 62, 65) zum Aufteilen des Gasstroms aus der Einlassöffnung (4, 54, 104, 154) aufweist, wobei bevorzugt bei wenigstens einer der zumindest einen Lochplatte (58, 64) die freie Querschnittsfläche der Löcher (60, 61, 62, 65) mit dem Abstand zur Einlassöffnung (4, 54, 104, 154) in der zumindest einen Leitung (6, 56, 106) variiert und/oder bevorzugt mehrere Lochplatten (58, 64) in der zumindest einen Leitung (6, 56, 106) in Strömungsrichtung der mehreren Gasströmungen nacheinander liegend angeordnet sind, wobei besonders bevorzugt dazwischen getrennte Teilleitungen angeordnet sind, die die mehreren Gasströmungen zumindest bereichsweise leiten, und/oder
die Gasströmungsaufteilungseinrichtung (8, 58, 64, 108) in der zumindest einen Leitung (6, 56, 106) zum Leiten des Gasstroms aus der Einlassöffnung (4, 54, 104, 154) zumindest eine Trennwand (9, 59, 109) aufweist, wobei die zumindest eine Trennwand (9, 59, 109) den Gasstrom aus der Einlassöffnung (4, 54, 104, 154) aufteilt und in zumindest zwei Teilleitungen leitet, die zu unterschiedlichen Abschnitten des Fensters (3, 53, 103, 153) führen, wobei bevorzugt die zumindest eine Trennwand (9, 109) unmittelbar an der Einlassöffnung (4, 54, 104, 154) beginnt.

7. Infrarot-Modul oder UV-Modul (150) nach einem der vorangehenden Ansprüche, **dadurch gekennzeichnet, dass**
in der zumindest einen Leitung (6, 56, 106) zumindest ein Drucksensor zum Bestimmen des Gasdrucks in der zumindest einen Leitung (6, 56, 106) angeordnet ist und/oder an dem Fenster (3, 53, 103, 153) zumindest ein Bruchsensor zum Erkennen eines Bruchs des Fensters (3, 53, 103, 153) angeordnet ist und/oder an einem Teil des Modulgehäuses (2, 52, 102, 152) zumindest ein Temperatursensor zum Bestimmen der Temperatur wenigstens einer Oberfläche oder eines Teils des Modulgehäuses (2, 52, 102, 152) angeordnet ist, wobei bevorzugt das Infrarot-Modul oder UV-Modul (150) eine Steuerung zur Auswertung der Messsignale des zumindest einen Drucksensors und/oder des zumindest einen Bruchsensors und/oder des zumindest einen Temperatursensors aufweist, wobei besonders bevorzugt die Steuerung den Volumenstrom des Gasstroms aus der Einlassöffnung (4, 54, 104, 154) aufgrund der Messung des zumindest einen Temperatursensors steuert und/oder die Steuerung bei einem unerwarteten Druckabfall und/oder bei einer Erkennung eines Bruchs des Fensters (3, 53, 103, 153) und/oder bei einem unerwarteten Temperaturanstieg ein Signal abgibt, ganz besonders bevorzugt ein Alarm-Signal und/oder ein Signal zum Unterbrechen des Betriebs des zumindest einen Strahlers (1, 51, 151) und/oder einer Trocknungsanlage oder Härtungsanlage, in der das Infrarot-Modul oder UV-Modul (150) eingebaut ist.

8. Infrarot-Modul (150) nach einem der vorangehenden Ansprüche, **dadurch gekennzeichnet, dass**
jeder der zumindest einen Infrarotstrahler ein Heizelement (26, 76) und ein Hüllrohr (24, 74) aufweist, wobei das Hüllrohr (24, 74) das Heizelement (26, 76) außen umschließt und das Hüllrohr (24, 74) zumindest bereichsweise oder vollständig für Infrarotstrahlung eines Wellenlängenbereichs durchlässig ist, oder der zumindest eine Infrarotstrahler ein Keramikstrahler ist.

9. Infrarot-Modul oder UV-Modul (150) nach einem der vorangehenden Ansprüche, **dadurch gekennzeichnet, dass**
das Fenster (3, 53, 103, 153) aus Quarzglas besteht und/oder
der zumindest eine Infrarotstrahler ein Carbon-Heizelement, ein Siliziumcarbid-Heizelement oder ein aus einem hochtemperaturstabilen Metall bestehendes Heizelement aufweist oder der zumindest eine UV-Strahler mehrere UV-LEDs oder einen Quecksilber-Strahler, einen Amalgam-Strahler oder einen Excimer-Strahler aufweist.

10. Infrarot-Modul oder UV-Modul (150) nach einem der vorangehenden Ansprüche, **dadurch gekennzeichnet, dass**
die zumindest eine Leitung (6, 56, 106) und die Gasströmungsaufteilungseinrichtung (8, 58, 64, 108) des Modulgehäuses (2, 52, 102, 152) den Gasstrom und die mehreren Gasströme derart leitet, dass diese nicht mehrfach nacheinander über eine sich im Betrieb des Infrarot-Moduls oder UV-Moduls (150) erhitzende Oberfläche des Infrarot-Moduls oder UV-Moduls (150) geleitet werden, bevorzugt die zumindest eine Leitung (6, 56, 106) und die Gasströmungsaufteilungseinrichtung (8, 58, 64, 108) des Modulgehäuses (2, 52, 102, 152) den Gasstrom und die mehreren Gasströme derart leiten, dass die mehreren Gasströme nur einmal über eine sich im Betrieb des Infrarot-Moduls oder UV-Moduls (150) erhitzende Oberfläche des Infrarot-Moduls oder UV-Moduls (150) geleitet werden, besonders bevorzugt die zumindest eine Leitung (6, 56, 106) und die Gasströmungsaufteilungseinrichtung (8, 58, 64, 108) des Modulgehäuses (2, 52, 102, 152) den Gasstrom und die mehreren Gasströme derart leiten, dass die mehreren Gasströme nur einmal über eines der Bauteile der Gruppe bestehend aus dem Fenster (3, 53, 103, 153), dem zumindest einen Strahler (1, 51, 151) und dem zumindest eine Reflektor (20, 70) geleitet werden.

11. Bearbeitungsanlage zur Veränderung eines Stoffs mittels Infrarotstrahlung oder UV-Strahlung, die Bearbeitungsanlage aufweisend zumindest ein Infrarot-Modul oder UV-Modul (150) nach einem der vorangehenden Ansprüche, wobei die Bearbeitungsanlage zumindest eine Halterung (164, 166) zum Anordnen eines zu verändernden Stoffs und/oder eine Fördereinrichtung zum Fördern des zu verändernden Stoffs, insbesondere eines Drahts (166) oder Bands, in einem Lichtkegel der aus dem Fenster (3, 53, 103, 153) des zumindest einen Infrarot-Moduls oder UV-Moduls (150) austretenden Infrarotstrahlung oder UV-Strahlung aufweist, wobei vorzugsweise die Bearbeitungsanlage einen Prozessraum (163) aufweist, der durch zumindest einen Teil des Modulgehäuses (2, 52, 102, 152) und durch das Fenster (3, 53, 103, 153) von einem Innenraum des Modulgehäuses (2, 52, 102, 152) getrennt ist, besonders bevorzugt gasdicht und/oder druckdicht getrennt ist.

12. Verfahren zum Betreiben eines Infrarot-Moduls oder UV-Moduls (150) nach einem der Ansprüche 1 bis 10 oder einer Bearbeitungsanlage nach Anspruch 11, **gekennzeichnet durch** die Schritte:
A) Einspeisen eines Gasstroms durch die Einlassöffnung (4, 54, 104, 154) in das Modulgehäuse (2, 52, 102, 152);
B) Teilen des Gasstroms in mehrere Gasströmungen;
C) Überspülen von Abschnitten der innenliegenden Oberfläche des Fensters (3, 53, 103, 153) des Modulgehäuses (2, 52, 102, 152) mit den mehreren Gasströmungen und dadurch Kühlen des Fensters (3, 53, 103, 153) mit den mehreren Gasströmungen; und
D) Ableiten der mehreren Gasströmungen aus dem Modulgehäuse (2, 52, 102, 152) heraus;
wobei während der Schritte A) bis D) Infrarotstrahlung oder UV-Strahlung mit dem zumindest einen Strahler (1, 51, 151) erzeugt wird und durch das Fenster (3, 53, 103, 153) aus dem Infrarot-Modul oder UV-Modul (150) abgestrahlt wird.

13. Verfahren nach Anspruch 12, **dadurch gekennzeichnet, dass**
während des Verfahrens eine Temperatur im Modulgehäuse (2, 52, 102, 152) und/oder der Druck des Gases an zumindest einer Stelle der zumindest einen Leitung (6, 56, 106) und/oder das Vorliegen eines Bruchs des Fensters (3, 53, 103, 153) gemessen wird, wobei bevorzugt das Erzeugen von Infrarotstrahlung oder von UV-Strahlung mit dem zumindest einen Strahler (1, 51, 151) unterbrochen wird, wenn ein Temperaturabfall, ein Druckabfall und/oder ein Bruch des Fensters (3, 53, 103, 153) detektiert wird, und/oder der Volumenstrom des Gasstroms durch die Einlassöffnung (4, 54, 104, 154) in das Modulgehäuse (2, 52, 102, 152) unterbrochen oder gesteuert wird, wenn eine Temperaturänderung, eine Druckänderung und/oder ein Bruch des Fensters (3, 53, 103, 153) detektiert wird.

14. Verfahren nach einem der Ansprüche 12 oder 13, **dadurch gekennzeichnet, dass**
das Verfahren mit einem Überdruck im Inneren des Modulgehäuses (2, 52, 102, 152) gegenüber einem Druck auf einer der innenliegenden Seite des Fensters (3, 53, 103, 153) gegenüberliegenden Außenseite des Fensters (3, 53, 103, 153) durchgeführt wird, insbesondere gegenüber einem Druck in einem Prozessraum (163) durchgeführt wird, wobei vorzugsweise bei einem Leck oder einem Bruch des Modulgehäuses (2, 52, 102, 152) Gas aus dem Inneren des Modulgehäuses (2, 52, 102, 152) in die Umgebung des Modulgehäuses (2, 52, 102, 152) oder in den Prozessraum (163) strömt, und/oder
in Schritt A) der Gasstrom gefiltert und/oder gereinigt wird, bevor er in die mehreren Gasströmungen geteilt wird.

15. Verfahren nach einem der Ansprüche 12 bis 14, **dadurch gekennzeichnet, dass**
ein Teil der von dem zumindest einen Strahler (1, 51, 151) ausgehenden Infrarotstrahlung oder UV-Strahlung von einer die Infrarotstrahlung oder die UV-Strahlung reflektierenden Oberfläche eines Reflektors (20, 70) durch das Fenster (3, 53, 103, 153) reflektiert wird, wobei die mehreren Gasströmungen in Schritt C) die Infrarotstrahlung oder UV-Strahlung reflektierende Oberfläche des Reflektors (20, 70) abschnittsweise überspülen und dadurch kühlen, und/oder
in Schritt C) ein Überspülen von Abschnitten von äußeren Oberflächen des zumindest einen Strahlers (1, 51, 151) mit den mehreren Gasströmungen erfolgt und dadurch ein Kühlen der Oberfläche des Strahlers (1, 51, 151) mit den mehreren Gasströmungen erfolgt.
